# EUROPEAN PATENT APPLICATION

(11) **EP 1 601 028 A1**
(43) Date of publication of application: **30.11.2005**
(21) Application number: 05703527.1
(22) Date of filing: 13.01.2005
(51) Int. Cl.: H01L 33/00, H01S 5/20

(54) **OPTICAL SEMICONDUCTOR DEVICE AND ITS MANUFACTURING METHOD**

(30) Priority: 28.01.2004 JP 2004020180; 14.09.2004 JP 2004266963
(71) Applicant: ANRITSU CORPORATION, Atsugi-shi, Kanagawa 243-8555 (JP)
(72) Inventor: Yamada, Atsushi, c/o Intell. Prop. Prom. Dpt, Kanagawa, 243-8555 (JP); Nagashima, Yasuaki, c/o Intell. Pro. Prom. Dpt, Kanagawa, 243-8555 (JP); Shimose, Yoshiharu, c/o Intell. Pro. Prom. Dpt, Kanagawa, 243-8555 (JP); Kikugawa, Tomoyuki, c/o Intell. Prop. Prom Dpt, Kanagawa, 243-8555 (JP)
(74) Representative: Pautex Schneider, Nicole Véronique
(86) International application number: PCT/JP2005/000288
(87) International publication number: WO 2005/074047

(57) **Abstract**

An optical semiconductor device (1) has a semiconductor substrate (2) made of InP, an active layer (7) which is formed in parallel with a top surface (2a) of the semiconductor substrate (2) above the semiconductor substrate (2), an n-type first cladding layer (6) made of InGaAsP which is formed under the active layer (7), a p-type second cladding layer (8) made of InP which is formed under the active layer (7), and window regions (4a, 4b) which are formed at least one light-emitting facet of both light-emitting facets of the active layer (7). The window regions are formed between device facets (1a, 1b) from the light-emitting facet. A relationship is established in which, given that a refractive index of the n-type first cladding layer (6) is na, and a refractive index of the p-type second cladding layer (8) is nb, na > nb is obtained that the refractive index na of the n-type first cladding layer (6) is higher than the refractive index nb of the p-type second cladding layer (8), so as to deflect a distribution of electric field strength of a light generated at the active layer (7) toward the n-type first cladding layer (6) side.

## Description

### Technical Field

The present invention relates to an optical semiconductor device and a method of manufacturing the same, and in particular, to an optical semiconductor device having window regions in which an active layer ends in the vicinity of the facets, the optical semiconductor device being used as a semiconductor light amplifier or a tunable wavelength light source apparatus, and a method of manufacturing the same.

### Background Art

As is well known, for example, semiconductor light amplifiers using a semiconductor light emitting diode are broadly divided into resonant semiconductor light amplifiers and traveling-wave semiconductor light amplifiers.

The resonant semiconductor light amplifier uses a semiconductor laser so as to be biased to be less than or equal to a threshold value.

The traveling-wave semiconductor light amplifier suppresses the facet reflectance factors of the both facets of a semiconductor laser by using means such as AR coating or a window facet structure.

This traveling-wave semiconductor light amplifier is advantageous to the resonant semiconductor light amplifier because of the reason that a variation of gain with respect to a variation in an input light wavelength and an intensity of saturation gain with respect to an increase in an input light intensity are large.

However, in order to obtain a traveling-wave semiconductor light amplifier with excellent characteristics, it is necessary to suppress the facet reflectance factors to be low, for example, less than or equal to 0.1%.

However, in the traveling-wave semiconductor light amplifier, it is extremely difficult to obtain desired facet reflectance factors with satisfactory reproducibility by only an AR coating technology which has been conventionally used.

Therefore, in a conventional traveling-wave semiconductor light amplifier, the facet reflectance factors are suppressed by using a window facet structure having window regions in which an active layer ends in the vicinity of the facets.

FIG. 13 shows a schematic perspective view of a semiconductor light amplifier as disclosed in the following Patent Document 1, as a conventional traveling-wave semiconductor light amplifier having a window facet structure in which an active layer ends in the vicinity of the facets.

FIG. 14 is an enlarged view of a portion of the window facet structure of the semiconductor light amplifier shown in FIG. 13.

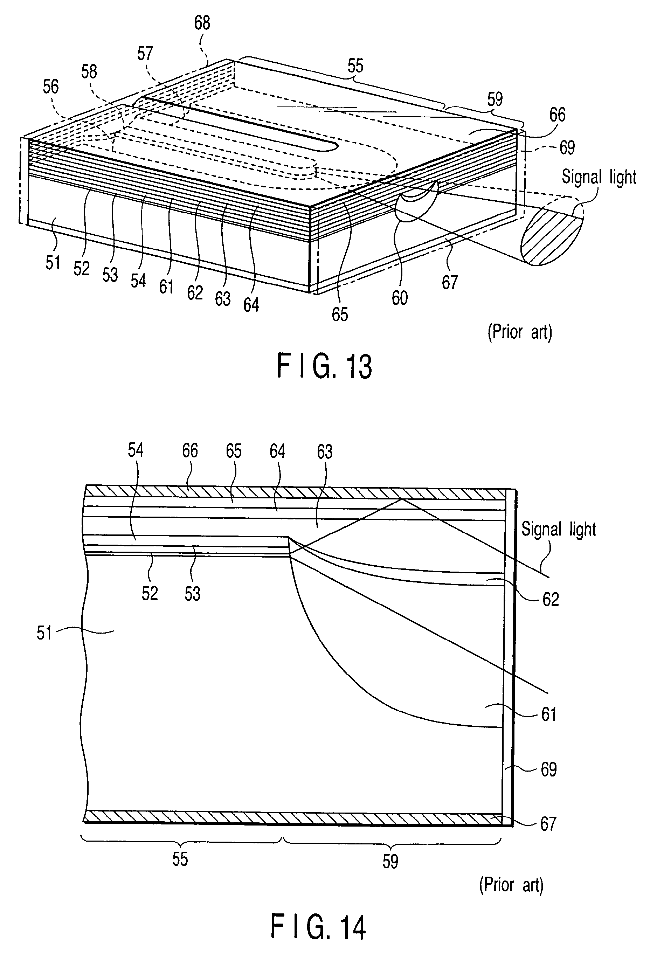

Hereinafter, the configuration of the semiconductor light amplifier having a window facet structure will be described in accordance with the procedure of its manufacturing processes with reference to FIGS. 13 and 14.

As shown in FIG. 13, first, a non-doped InGaAsP active layer 52, an antimelt back layer (AMB layer) 53, and a p-InP cladding layer 54 are crystal-grown on the top surface of an n-InP substrate 51 such that the respective thicknesses become 0.1 µm, 0.01 µm, and 1 µm by a liquid phase epitaxy (LPE) method.

Thereafter, at a portion corresponding to an active region 55 of a multilayer semiconductor crystal, two parallel round grooves 56 and 57 whose depths are 1.5 µm and whose widths are 4 µm, and a mesa stripe 58 having of 1.2 µm which is provided between those groves 56 and 57 are formed in [110] direction.

Further, at a portion corresponding to a window region 59, a round groove 60 having a width of 4 µm and depth of 1.5 µm which continues from the groves 56 and 57 and at which the mesa stripe 58 does not exist is formed.

Note that the length of the window region 59 is 50 µm.

Next, on the semiconductor multilayer crystal other than the top portion of the mesa stripe 58, a p-InP current block layer 61 and an n-InP current block layer 62 are crystal-grown, and on the entire surface, a p-InP buried layer 63 and p⁺-InGaAsP contact layer 64 whose wavelength composition is 1.2 µm are crystal-grown, such that the thicknesses at the flat portions are respectively made 1 µm, 0.5 µm, 2 µm, and 0.5 µm in this order by an LPE method.

An SiO₂ film 65 whose thickness is 3000 angstroms is formed by a CVD method on the contact layer 64, and a window is opened at a portion of the SiO₂ film 65 corresponding to the portion directly above the mesa stripe 58.

Moreover, an electrode 66 made of Cr/Au is formed so as to cover the SiO₂ film 65 and the window portion of the SiO₂ film 65, and an electrode 67 made of AuGeNi is formed under the n-InP substrate 51.

Finally, SiN films 68 and 69 whose thicknesses are 2200 angstroms are formed at the facets thereof at the active region 55 side and the window region 59 side by a plasma CVD method.

Incidentally, in a device including the semiconductor light amplifier described above which is used so as to suppress the oscillation, the window structure in which an active layer ends in the vicinity of the facets is effective, and in contrast thereto, the layer thickness at the p-side is made thinner than the length of the window region.

Specifically, in the semiconductor light amplifier shown in FIGS. 13 and 14, the thickness of the p-InP buried layer 63 is formed so as to be about 2 µm which is thinner than the length of 50 µm of the window region 59.

Therefore, there is the problem that a light emitted from the active layer 52 is reflected on the top surface electrode 66, and the reflected light and a direct light from the active layer 52 interfere with each other, which brings about turbulence in an emission pattern.

Further, in the semiconductor light amplifier shown in FIGS. 13 and 14, there is the problem that a coupling efficiency at the time of being optically coupled with a single-mode optical fiber from the exterior is low due to the turbulence in the emission pattern.

As an optical semiconductor device for solving the above-described problems, for example, a semiconductor light amplifier as disclosed in the following Patent Document 1 has been known.

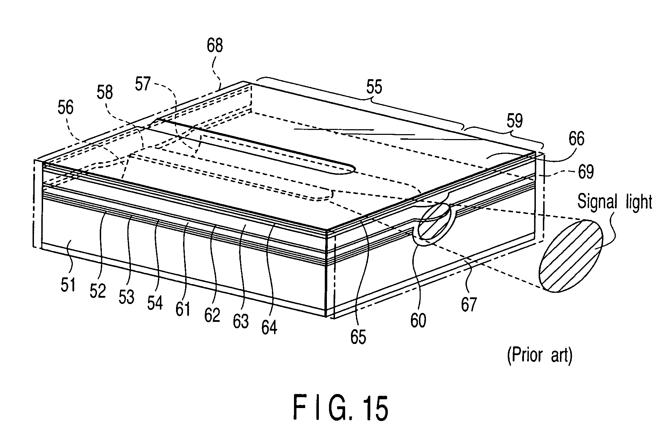

Hereinafter, as an optical semiconductor device for solving the above-described problems, the configuration of the semiconductor light amplifier disclosed in the Patent Document 1 will be described in accordance with the procedure of the manufacturing processes with reference to FIG. 15.

Note that, in the semiconductor light amplifier of FIG. 15, components which are the same as those of the semiconductor light amplifier of FIGS. 13 and 14 are denoted by the same reference numbers, and the configuration will be described.

As shown in FIG. 15, first, the non-doped InGaAsP active layer 52, the antimelt back layer (AMP layer) 53, and the p-InP cladding layer 54 are crystal-grown on the top surface of the n-InP substrate 51 such that the thicknesses are respectively in the order of 0.1 µm, 0.01 µm, and 1 µm by a liquid phase epitaxy (LPE) method.

Thereafter, at a portion corresponding to the active region 55 of the multilayer semiconductor crystal, the two grooves 56 and 57 whose depths are 1.5 µm and whose widths are 4 µm, and the mesa stripe 58 having width of 1.5 µm which is provided between those groves 56 and 57 are formed in the [110] direction.

Further, at a portion corresponding to the window region 59, the round groove 60 having a width of 4 µm and depth of 1.5 µm which continues from the groves 56 and 57 and at which the mesa stripe 58 does not exist is formed.

Note that the length of the window region 59 is 50 µm.

Next, on the above-described semiconductor multilayer crystal other than the top portion of the mesa stripe 58, the p-InP current block layer 61 and the n-InP current block layer 62 are crystal-grown, and on the entire surface, the p-InP buried layer 63 and the p⁺-InGaAsP contact layer 64 whose wavelength composition is 1.2 µm are crystal-grown, such that the thicknesses at the flat portions are respectively made 1 µm, 0.5 µm, 2 µm, and 0.5 µm in this order by an LPE method.

Here, the thickness of the p-InP buried layer 63 is made to be 6 µm, which is greater than 5.5 µm, the radius of the beam spot, in consideration of the fact that the diameter of the beam spot of the light emitted from the active layer 52 becomes 11 µm at the facet thereof.

An SiO₂ film 65 whose thickness is 3000 angstroms is formed by a CVD method on the contact layer 64, and a window is opened at a portion of the SiO₂ film 65 corresponding to the portion directly above the mesa stripe 58.

Moreover, the electrode 66 made of Cr/Au is formed so as to cover the SiO₂ film 65 and the window portion of the SiO₂ film 65, and the electrode 67 made of AuGeNi is formed under the n-InP substrate 51.

Finally, the SiON films 68 and 69 whose thicknesses are 2200 angstroms are formed by an ECR plasma CVD method at the both facets thereof.

In accordance with the thus configured semiconductor light amplifier, the thickness of the p-InP buried layer 63 is greater than the radius of the beam spot of the light emitted from the active layer 52, and therefore, there is no light scattering due to the electrode in the vicinity of the window facet, and a satisfactory coupling efficiency can be obtained in coupling by using a SELFOC lens.

Further, a gain of light amplification between fibers of 18 dB can be obtained when an injecting current is 70 mA with respect to an incident light whose wavelength is 1.55 µm and whose intensity is -35 dBm.

The variation in an amplification factor when the incident light is swept with a wavelength of 15 angstroms (that is greater than or equal to a free spectrum range for a Fabry-Perot mode) is 2 dB, which is extremely small.

This is brought about as a result of suppressing the average facet reflectance factor to 0.1% or less, by using the window facet structure for the light amplifier.
Patent Document 1: Jpn. Pat. Appln. KOKAI Publication No. 1-321675 (Patent No. 2643319). However, in the semiconductor light amplifier disclosed in the Patent Document 1, for the purpose of preventing the influence of the light interference between a reflected light obtained such that a light emitted from the active layer 52 in the window facet structure is reflected on the top surface electrode 66 and a direct light, the p-InP buried layer 63 formed on the n-InP substrate 51 is made to grow by using a vapor phase epitaxy method, whereby the layer thickness thereof is 6 µm, which is greater than 5.5 µm, the radius of the beam spot of the light emitted from the active layer 52.

Therefore, in the above-described semiconductor light amplifier disclosed in the Patent Document 1, there are the problems that not only the layer thickness of the entire optical semiconductor device increases, but also it takes time for carrying out vapor phase epitaxy onto the p-InP buried layer 63, which unnecessarily increases the manufacturing time of the entire optical semiconductor device, which brings about a higher cost.

### Disclosure of Invention

The present invention has been achieved in consideration of the above-described problems. In order to realize an optical semiconductor device which can easily suppress the influence of interference at a window region which an active layer is breaked in the vicinity of the facets, an object of the present invention is to provide an optical semiconductor device which can suppress the generation of an undesired reflected light so as not to bring about undesired scattering or diffraction at a window region in the light generated at the active layer by shifting the distribution of electric field intensity of a light generated at the active layer from a p-type cladding layer side to an n-type cladding layer side, and which can effectively suppress the influence of interference due to a reflected light from an electrode without the layer thickness of the cladding layer at the p-side being made thick as in the prior art, and without taking a manufacturing time or increasing the cost, and to provide a method of manufacturing the optical semiconductor device.

In order to achieve the above object, according to a first aspect of the present invention, there is provided an optical semiconductor device comprising:
a semiconductor substrate (2) made of InP;
an active layer (7) which is formed in parallel with a top surface (2a) of the semiconductor substrate above the semiconductor substrate (2);
an n-type first cladding layer (6) made of InGaAsP, which is formed under the active layer (7);
a p-type second cladding layer (8) made of InP, which is formed above the active layer (7); and
at least one window region (4a, 4b) which is formed at at least one light-emitting facet of both light-emitting facets of the active layer (7), the window region being formed between at least one of the device facets (1a, 1b) from the at least one light-emitting facet, wherein
a relationship is established in which, given that a refractive index of the n-type first cladding layer (6) is na, and a refractive index of the p-type second cladding layer (8) is nb, na > nb is obtained that the refractive index na of the n-type first cladding layer (6) is higher than the refractive index nb of the p-type second cladding layer (8), so as to deflect a distribution of electric field strength of a light generated at the active layer (7) toward the n-type first cladding layer (6) side.

In order to achieve the above object, according to a second aspect of the present invention, there is provided an optical semiconductor device according to the first aspect, wherein a length of the window region (4a, 4b) is set to a length which enables to enlarge a beam spot size at the device facet (1a, 1b) having the window region (4a, 4b).

In order to achieve the above object, according to a third aspect of the present invention, there is provided a optical semiconductor device according to the first aspect, further comprising:
a mesa stripe portion (3) in which some of respective layers of the n-type first cladding layer (6), the active layer (7), and the p-type second cladding layer (8) are formed in a mesa type;
a current block portion (5) including: first current block layers (9) made of p-type InP, which are formed so as to contact the semiconductor substrate (2) and the n-type first cladding layer (6) with each one plane thereof at both sides of the mesa stripe portion (3); and second current block layers (10) made of n-type InP, which are formed so as to contact the p-type second cladding layer (8) with each one plane thereof at the both sides of the respective layers formed in a mesa type, and so as to contact each another plane of the first current block layers (9) with each another plane thereof;
a p-type third cladding layer (11) which covers a top surface of the mesa stripe portion (3) and a top surface of the current block portion (5) in common;
a p-type contact layer (12) formed above the p-type third cladding layer (11);
a first electrode (13) attached to a top surface of the p-type contact layer (12);
a second electrode (14) attached to a lower side of the semiconductor substrate (2); and
at least one antireflective film (15a, 15b) formed at at least one of the device facets (1a, 1b) having the window region (4a, 4b) of an optical semiconductor device (1) cut down as the optical semiconductor device (1) by cleavage.

In order to achieve the above object, according to a fourth aspect of the present invention, there is provided an optical semiconductor device according to the first aspect, further comprising:
a first separate confinement heterostructure (SCH) layer (16) made of InGaAsP, which is formed between the active layer (7) and the n-type first cladding layer (6); and
a second SCH layer (17) made of InGaAsP, which is formed between the active layer (7) and the p-type second cladding layer (8), wherein
respective refractive indexes of the first SCH layer (16) and the second SCH layer (17) are set to be higher than the refractive index of the n-type first cladding layer (6).

In order to achieve the above object, according to a fifth aspect of the present invention, there is provided an optical semiconductor device according to the fourth aspect, wherein the active layer (7) includes a multi quantum well (MQW) structure having a plurality of layers including a plurality of well layers and a plurality of barrier layers which are positioned at both sides of each well layer in the plurality of well layers.

In order to achieve the above object, according to a sixth aspect of the present invention, there is provided an optical semiconductor device according to the fifth aspect, wherein
the first SCH layer (16) includes a multilayer structure formed from a plurality of layers, and
the second SCH layer (17) includes a multilayer structure formed from a plurality of layers.

In order to achieve the above object, according to a seventh aspect of the present invention, there is provided an optical semiconductor device according to the sixth aspect, wherein
a great and small relationship among refractive indexes of the respective layers of the plurality of barrier layers in the active layer (7), the plurality of layers in the first SCH layer (16), and the plurality of layers in the second SCH layer (17) is set such that the refractive index of the plurality of barrier layers in the active layer (7) is highest, and the refractive indexes are made lower as are separated away from the active layer (7), including the relationship in which the refractive index na of the n-type first cladding layer (6) is higher than the refractive index nb of the p-type second cladding layer (8).

In order to achieve the above object, according to an eighth aspect of the present invention, there is provided an optical semiconductor device according to the seventh aspect, further comprising:
a mesa stripe portion (3) in which some of the respective layers of the n-type first cladding layer (6), the first SCH layer (16), the active layer (7), the second SCH layer (17), and the p-type second cladding layer (8) are formed in a mesa type;
a current block portion (5) including: first current block layers (9) made of p-type InP, which are formed so as to contact the semiconductor substrate (2) and the n-type first cladding layer (6) with each one plane thereof at both sides of the mesa stripe portion (3); and second current block layers (10) made of n-type InP, which are formed so as to contact the p-type second cladding layer (8) with each one plane thereof at both sides of the respective layers formed in a mesa type, and so as to contact each another plane of the first current block layers (9) with each another plane thereof;
a p-type third cladding layer (11) which covers a top surface of the mesa stripe portion (3) and a top surface of the current block portion (5) in common;
a p-type contact layer (12) formed above the p-type third cladding layer (11);
a first electrode (13) attached to a top surface of the p-type contact layer (12);
a second electrode (14) attached to a lower side of the semiconductor substrate (2); and
at least one antireflective film (15a, 15b) formed at at least one of the device facet (1a, 1b) having the window region (4a, 4b) of an optical semiconductor device (1) cut down as the optical semiconductor device (1) by cleavage.

In order to achieve the above object, according to a ninth aspect of the present invention, there is provided an optical semiconductor device according to the third or eighth aspect, wherein
at least one facet of both facets (3a, 3b) of the mesa stripe portion (3) is inclined at a predetermined angle β with respect to a longitudinal direction which is an output direction of a light (21) generated at the active layer (7), and is formed so as to be an acute angle inclined at a predetermined angle θ with respect to a direction perpendicular to the longitudinal direction.

In order to achieve the above object, according to a tenth aspect of the present invention, there is provided an optical semiconductor device according to the third or eighth aspect, wherein the mesa stripe portion (3) is formed to be a layout structure in which the mesa stripe portion is inclined at a predetermined angle in the longitudinal direction thereof.

In order to achieve the above object, according to an eleventh aspect of the present invention, there is provided an optical semiconductor device according to the third or eighth aspect, wherein
the window region (4a, 4b) is formed such that one is as a window region (4a) which is coupled with an optical fiber, and another one is as a window region (4b) which is not coupled with an optical fiber at the both light-emitting facets of the active layer (7),
a region length of the window region (4b) which is not coupled with an optical fiber is longer than a region length of the window region (4a) which is coupled with an optical fiber, and
the mesa stripe portion (3), in the longitudinal direction, is formed to make a right angle with the surfaces of the antireflective film (15a) which is output facet, so that the device is applied as a super luminescence diode.

In order to achieve the above object, according to a twelfth aspect of the present invention, there is provided an optical semiconductor device according to the third or eighth aspect, wherein
window regions (4a, 4b) are formed such that one is as a window region (4a) which is coupled with an optical fiber, and another one is as a window region (4b) which is not coupled with an optical fiber at the both light-emitting facets of the active layer (7),
a region length of the window region (4b) which is not coupled with an optical fiber is longer than a region length of the window region (4a) which is coupled with an optical fiber, and
the mesa stripe portion (3), in the longitudinal direction, is partially or entirely formed to be inclined at a predetermined angle so as to make an angle of an output light which is not a right angle with respect to the surfaces of the antireflective films (15a) which is output facet, so that the device is applied as super luminescence diode.

In order to achieve the above object, according to a thirteenth aspect of the present invention, there is provided an optical semiconductor device according to the third or eighth aspect, wherein
the window region (4a, 4b) is formed as a window region (4a) at only one light-emitting facet of the both light-emitting facets of the active layer (7),
one facet (3a) of the mesa stripe portion (3) is positioned inward by a distance of the window region (4a) from the facet (1a) of the optical semiconductor device (1) facing thereto, and is inclined at a predetermined angle β in an output direction of the light (21) generated at the active layer (7), and
another facet (3d) of the mesa stripe portion (3), at which the window region is not formed, is exposed to the facet (1b) of the optical semiconductor device (1) facing thereto, and is formed so as to be perpendicular to the longitudinal direction of the optical semiconductor device (1).

In order to achieve the above object, according to a fourteenth aspect of the present invention, there is provided a method of manufacturing an optical semiconductor device, comprising:
a step of preparing a semiconductor substrate (2) made of InP;
a step of forming an active layer (7) in parallel with a top surface (2a) of the semiconductor substrate above the semiconductor substrate (2);
a step of forming an n-type first cladding layer (6) made of InGaAsP under the active layer (7);
a step of forming a p-type second cladding layer (8) made of InP above the active layer (7); and
a step of forming at least one window region (4a, 4b) at at least one light-emitting facet of both light-emitting facets of the active layer (7), between at least one of the device facets (1a, 1b) from the light-emitting facet, wherein
a relationship is established in which, given that a refractive index of the n-type first cladding layer (6) is na, and a refractive index of the p-type second cladding layer (8) is nb, na > nb is obtained that the refractive index na of the n-type first cladding layer (6) is higher than the refractive index nb of the p-type second cladding layer (8), so as to deflect a distribution of electric field strength of a light generated at the active layer (7) toward the n-type first cladding layer (6) side.

In order to achieve the above object, according to a fifteenth aspect of the present invention, there is provided an method of manufacturing an optical semiconductor device, according to the fourteenth aspect, wherein a length of the window region (4a, 4b) is set to a length which enables to enlarge a beam spot size at the device facet (1a, 1b) having the window region (4a, 4b).

In order to achieve the above object, according to a sixteenth aspect of the present invention, there is provided an method of manufacturing an optical semiconductor device, according to the fourteenth aspect, further comprising:
a step of forming some of respective layers of the n-type first cladding layer (6), the active layer (7), and the p-type second cladding layer (8) as a mesa stripe portion (3) in a mesa type;
a step of forming a current block portion (5) including: first current block layers (9) made of p-type InP, which are formed so as to contact the semiconductor substrate (2) and the n-type first cladding layer (6) with each one plane thereof at both sides of the mesa stripe portion (3); and second current block layers (10) made of n-type InP, which are formed so as to contact the p-type second cladding layer (8) with each one plane thereof at the both sides of the respective layers formed in a mesa type, and so as to contact each another plane of the first current block layers (9) with each another plane thereof;
a step of forming a p-type third cladding layer (11) which covers a top surface of the mesa stripe portion (3) and a top surface of the current block portion (5) in common;
a step of forming a p-type contact layer (12) above the p-type third cladding layer (11);
a step of attaching a first electrode (13) to a top surface of the p-type contact layer (12);
a step of attaching a second electrode (14) to a lower side of the semiconductor substrate (2); and
a step of forming at least one antireflective film (15a, 15b) at at least one of the device facets (1a, 1b) having the window region (4a, 4b) of an optical semiconductor device (1) cut down as the optical semiconductor device (1) by cleavage.

In order to achieve the above object, according to a seventeenth aspect of the present invention, there is provided a method of manufacturing an optical semiconductor device, according to the fourteenth aspect, further comprising:
a step of forming a first separate confinement heterostructure (SCH) layer (16) made of InGaAsP between the active layer (7) and the n-type first cladding layer (6); and
a step of forming a second SCH layer (17) made of InGaAsP between the active layer (7) and the p-type second cladding layer (8), wherein
respective refractive indexes of the first SCH layer (16) and the second SCH layer (17) are set to be higher than a refractive index of the n-type first cladding layer (6).

In order to achieve the above object, according to an eighteenth aspect of the present invention, there is provided a method of manufacturing an optical semiconductor device, according to the fourteenth aspect, wherein the active layer (7) includes a multi quantum well (MQW) structure having a plurality of layers which includes a plurality of well layers and a plurality of barrier layers which are positioned at both sides of each well layer in the plurality of well layers.

In order to achieve the above object, according to a nineteenth aspect of the present invention, there is provided a method of manufacturing an optical semiconductor device, according to the eighteenth aspect, wherein
the first SCH layer (16) includes a multilayer structure formed from a plurality of layers, and
the second SCH layer (17) includes a multilayer structure formed from a plurality of layers.

In order to achieve the above object, according to a twentieth aspect of the present invention, there is provided a method of manufacturing an optical semiconductor device, according to the nineteenth aspect, wherein
a great and small relationship among refractive indexes of respective layers of the plurality of barrier layers in the active layer (7), the plurality of layers in the first SCH layer (16), and the plurality of layers in the second SCH layer (17) is set such that the refractive index of the plurality of barrier layers in the active layer (7) is highest, and the refractive indexes are made lower as are separated away from the active layer (7) including the relationship in which the refractive index na of the n-type first cladding layer (6) is higher than the refractive index nb of the p-type second cladding layer (8).

In order to achieve the above object, according to a twenty-first aspect of the present invention, there is provided a method of manufacturing an optical semiconductor device, according to the twentieth aspect, further comprising:
a step of forming some of the respective layers of the n-type first cladding layer (6), the first SCH layer (16), the active layer (7), the second SCH layer (17), and the p-type second cladding layer (8) as a mesa stripe portion (3) in a mesa type;
a step of forming a current block portion (5) including: first current block layers (9) made of p-type InP, which are formed so as to contact the semiconductor substrate (2) and the n-type first cladding layer (6) with each one plane thereof at both sides of the mesa stripe portion (3); and second current block layers (10) made of n-type InP, which are formed so as to contact the p-type second cladding layer (8) with each one plane thereof at both sides of the respective layers formed in a mesa type, and so as to contact the other planes of the first current block layers (9) with each another plane thereof;
a step of forming a p-type third cladding layer (11) which covers a top surface of the mesa stripe portion (3) and a top surface of the current block portion (5) in common;
a step of forming a p-type contact layer (12) above the p-type third cladding layer (11);
a step of attaching a first electrode (13) to a top surface of the p-type contact layer (12);
a step of attaching a second electrode (14) to a lower side of the semiconductor substrate (2); and
a step of forming at least one antireflective film (15a, 15b) at at least one of the device facets (1a, 1b) having the window region (4a, 4b) of an optical semiconductor device (1) cut down as the optical semiconductor device (1) by cleavage.

In order to achieve the above object, according to a twenty-second aspect of the present invention, there is provided a method of manufacturing an optical semiconductor device, according to the sixteenth aspect, wherein
the step of forming a mesa stripe portion (3) comprises:
a step of successively forming a cap layer (32) on a top surface of the p-type second cladding layer (8), and a mask (33a) having a predetermined length S_{L} and a predetermined width S_{W}; and
a step of forming a mesa stripe portion (3) having a predetermined length Lₐ along a longitudinal direction on the semiconductor substrate (8) by means of one round etching onto the n-type first cladding layer (6), the active layer (7), the p-type second cladding layer (8), and the cap layer (32), at least one facet of both facets (3a, 3b) being inclined with respect to the longitudinal direction (an emission direction of a laser beam), and the mesa stripe portion being inclined with respect to a direction perpendicular to the longitudinal direction, and
at least one facet of the both facets (3a, 3b) of the mesa stripe portion (3) is inclined at a predetermined angle β with respect to the longitudinal direction which is an output direction of a light (21) generated at the active layer (7), and is formed so as to be an acute angle inclined at a predetermined angle θ with respect to a direction perpendicular to the longitudinal direction.

In order to achieve the above object, according to a twenty-third aspect of the present invention, there is provided a method of manufacturing an optical semiconductor device, according to the twenty-second aspect, wherein
the step of forming a mesa stripe portion (3) comprises:
a step of successively forming a cap layer (32) on a top surface of the p-type second cladding layer (8), and a mask (33a) having a predetermined length S_{L} and a predetermined width S_{W}; and
a step of forming a mesa stripe portion (3) having a predetermined length Lₐ along a longitudinal direction on the semiconductor substrate (2) by means of one round etching onto the n-type first cladding layer (6), the first SCH layer (16), the active layer (7), the second SCH layer (17), the p-type second cladding layer (8), and the cap layer (32), the facets (3a, 3b) being inclined with respect to the longitudinal direction (an emission direction of a laser beam), and the mesa stripe portion being inclined with respect to a direction perpendicular to the longitudinal direction, and
at least one facet of the both facets (3a, 3b) of the mesa stripe portion (3) is inclined at a predetermined angle β with respect to the longitudinal direction which is an output direction of a light (21) generated at the active layer (7), and is formed so as to be an acute angle inclined at a predetermined angle θ with respect to a direction perpendicular to the longitudinal direction.

In order to achieve the above object, according to a twenty-fourth aspect of the present invention, there is provided a method of manufacturing an optical semiconductor device, according to the sixteenth or twenty-first aspect, wherein
the step of forming a mesa stripe portion (3) comprises:
a step of forming the mesa stripe portion (3) to be a layout structure in which the mesa stripe portion is inclined at a predetermined angle in the longitudinal direction thereof.

In order to achieve the above object, according to a twenty-fifth aspect of the present invention, there is provided a method of manufacturing an optical semiconductor device, according to the sixteenth or twenty-first aspect, wherein
the step of forming window regions (4a, 4b) has:
a step of forming a window region (4a) having a predetermined region length which is coupled with an optical fiber at one light-emitting facet of the both light-emitting facets of the active layer (7); and
a step of forming a window region (4b) which has a region length longer than the region length of the window region (4a), and which is not coupled with an optical fiber, at the other light-emitting facet of the both light-emitting facets of the active layer (7), and
the mesa stripe portion (3), in the longitudinal direction, is formed to make a right angle with the surfaces of the antireflective films (15a) which are output facets, so that the device is applied as a super luminescence diode.

In order to achieve the above object, according to a twenty-sixth aspect of the present invention, there is provided a method of manufacturing an optical semiconductor device, according to the sixteenth or twenty-first aspect, wherein
the step of forming window regions (4a, 4b) comprises:
a step of forming a window region (4a) having a predetermined region length which is coupled with an optical fiber at one light-emitting facet of the both light-emitting facets of the active layer (7); and
a step of forming a window region (4b) which has a region length longer than the region length of the window region (4a), and which is not coupled with an optical fiber, at the other light-emitting facet of the both light-emitting facets of the active layer (7), and
the mesa stripe portion (3), in the longitudinal direction, is partially or entirely formed to be inclined at a predetermined angle so as to have an angle which is not a right angle with respect to the surfaces of the antireflective film (15a) which is output facet, so that the device is applied as a super luminescence diode.

In order to achieve the above object, according to a twenty-seventh aspect of the present invention, there is provided a method of manufacturing an optical semiconductor device, according to the sixteenth or twenty-first aspect, comprising:
a step of forming the window region (4a, 4b) as a window region (4a) at only one light-emitting facet of the both light-emitting facets of the active layer (7);
a step of forming one facet (3a) of the mesa stripe portion (3) so as to be positioned inward by a distance of the window region (4a) from the facet (1a) of the optical semiconductor device (1) facing thereto, and so as to be inclined at a predetermined angle β in an output direction of the light (21) generated at the active layer (7); and
a step of forming the other facet (3d) of the mesa stripe portion (3), at which the window region is not formed, so as to be exposed to the facet (1b) of the optical semiconductor device (1) facing thereto, and so as to be perpendicular to the longitudinal direction of the optical semiconductor device (1).

In order to achieve the above object, according to a twenty-eighth aspect of the present invention, there is provided a method of manufacturing an optical semiconductor device, according to the fourteenth aspect, wherein
the semiconductor substrate (2), the n-type first cladding layer (6), the active layer (7), and the p-type second cladding layer (8) each have a length that is double the length of the optical semiconductor device (1) to be manufactured in the longitudinal direction,
the window regions (4a, 4b) are respectively formed at the both light-emitting facets of the active layer (7),
the method further comprising:
a step of successively forming a cap layer (32) having a length that is double the optical semiconductor device (1) to be manufactured, on a top surface of the p-type second cladding layer (8), and a mask (33a) having a length shorter than the length that is double the optical semiconductor device (1) to be manufactured, and a predetermined width;
a step of forming an optical semiconductor device (1A) having a length that is double the optical semiconductor device (1) to be manufactured by forming a mesa stripe portion (3) having a length corresponding to the length that is double the optical semiconductor device (1) to be manufactured, along a longitudinal direction on the semiconductor substrate (2), by means of one round etching onto the n-type first cladding layer (6), the active layer (7), the p-type second cladding layer (8), and the cap layer (32), the both facets being inclined with respect to the longitudinal direction at a predetermined angle of inclination θ, and the mesa stripe portion being inclined at a predetermined angle of inclination β with respect to a direction perpendicular to the longitudinal direction; and
a step of sectioning the optical semiconductor device (1) to be manufactured by dividing the mesa stripe portion (3) of the optical semiconductor device (1A) having the length that is double the optical semiconductor device (1) to be manufactured into two at a central portion in the longitudinal direction by using a cleavage technique.

### Brief Description of Drawings

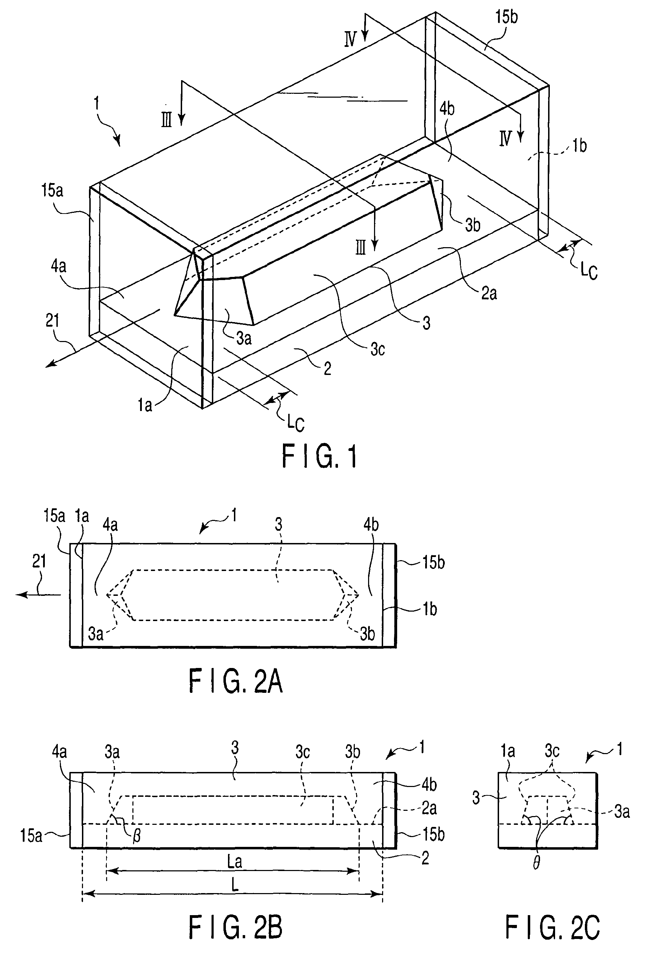

FIG. 1 is a perspective view showing a schematic configuration of a semiconductor device according to the invention.
FIG. 2A is a plan view showing the schematic configuration of the optical semiconductor device of FIG. 1.
FIG. 2B is a front view showing the schematic configuration of the optical semiconductor device of FIG. 1.
FIG. 2C is a side view showing the schematic configuration of the optical semiconductor device of FIG. 1.

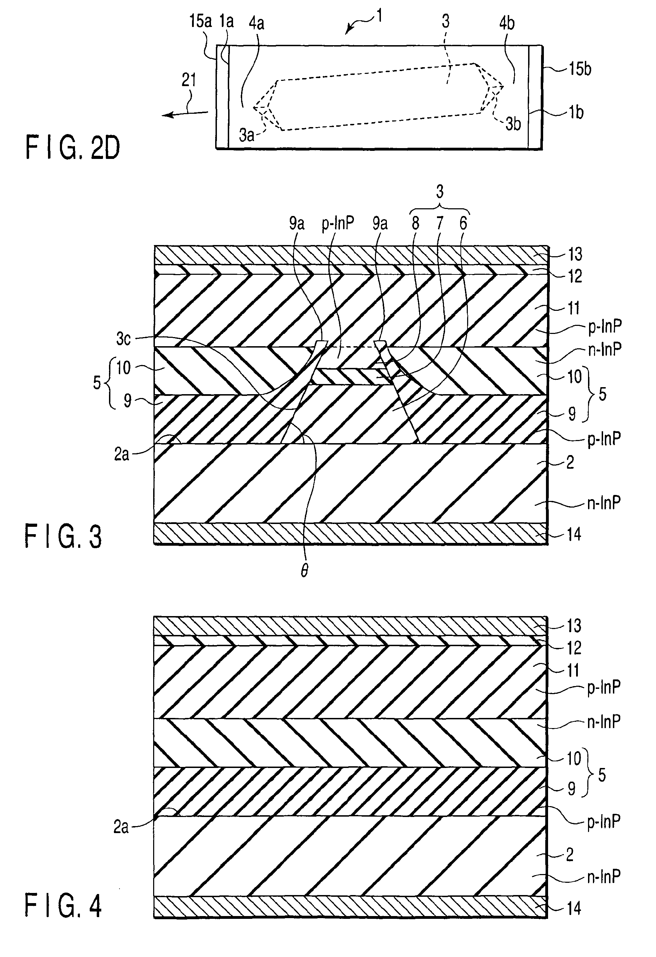

FIG. 2D is a plan view showing a modified example of a mesa stripe portion in FIG. 1.
FIG. 3 is a cross-sectional view when a central portion in the optical semiconductor device of FIG. 1 is cut along line III-III.
FIG. 4 is a cross-sectional view when an edge region in the optical semiconductor device of FIG. 1 is cut along line IV-IV.

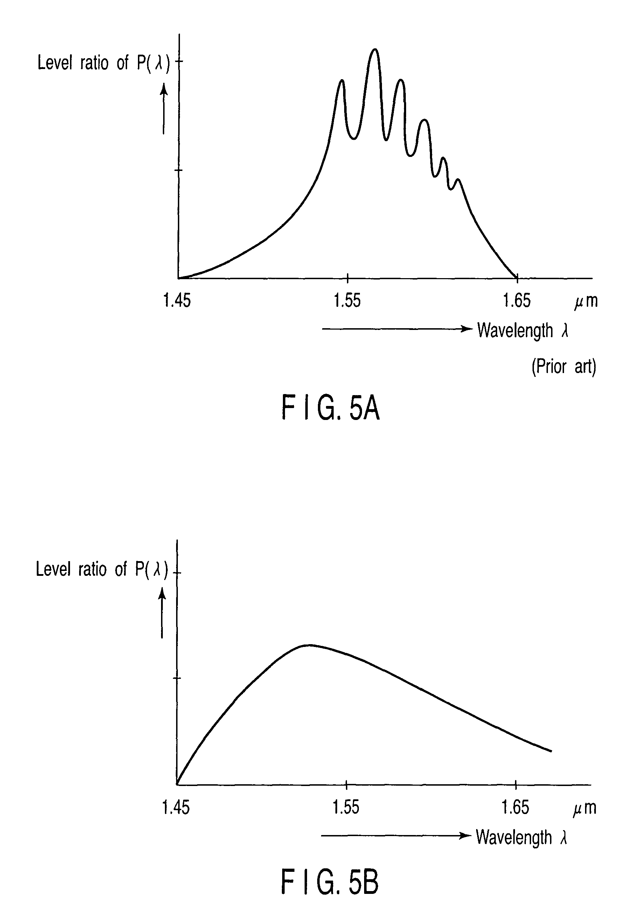

FIG. 5A is a graph showing wavelength characteristic of a conventional semiconductor light emitting device.
FIG. 5B is a graph showing wavelength characteristic of the optical semiconductor device according to the invention.

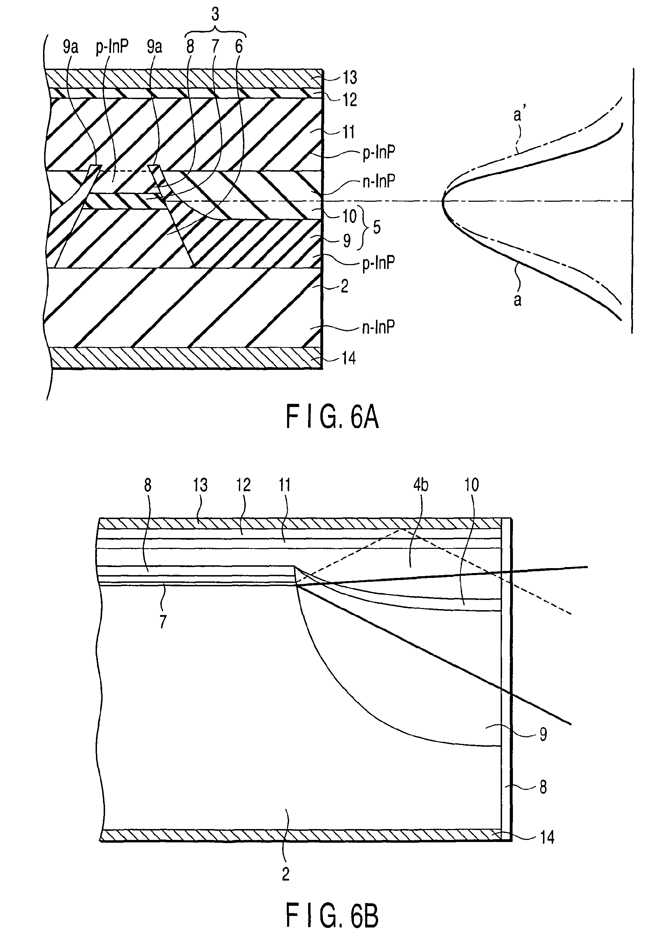

FIG. 6A is a view showing characteristic of a distribution of light of the optical semiconductor device according to the invention.
FIG. 6B is a partial enlarged cross-sectional view of a window structure portion of the optical semiconductor device according to the invention.

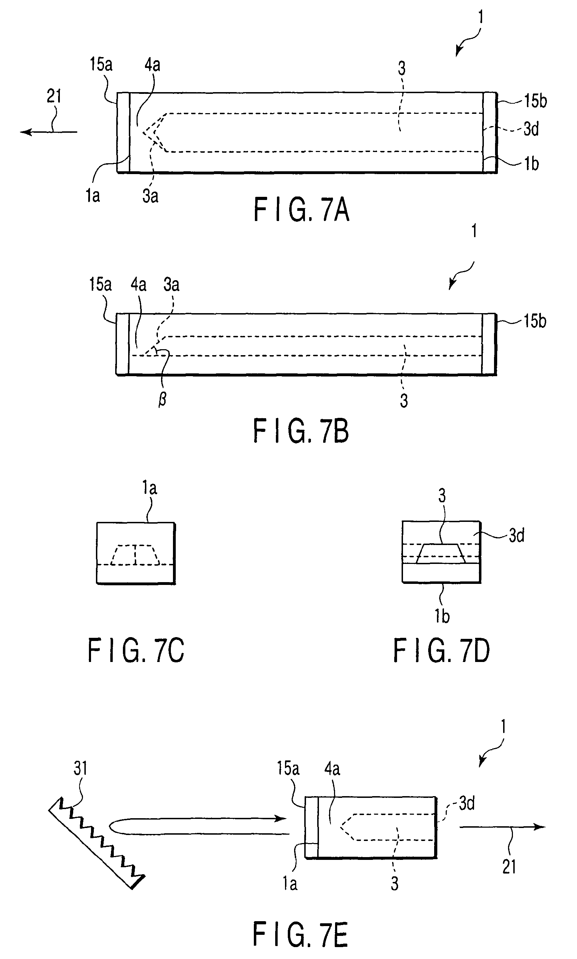

FIG. 7A is a plan view showing a schematic configuration of another mode of the optical semiconductor device according to the invention.
FIG. 7B is a front view showing the schematic configuration of the another mode of the optical semiconductor device according to the invention.
FIG. 7C is a left side view showing the schematic configuration of the another mode of the optical semiconductor device according to the invention.
FIG. 7D is a right side view showing the schematic configuration of the another mode of the optical semiconductor device according to the invention.
FIG. 7E is a schematic view of a tunable wavelength light source apparatus using the optical semiconductor device of FIG. 7A.

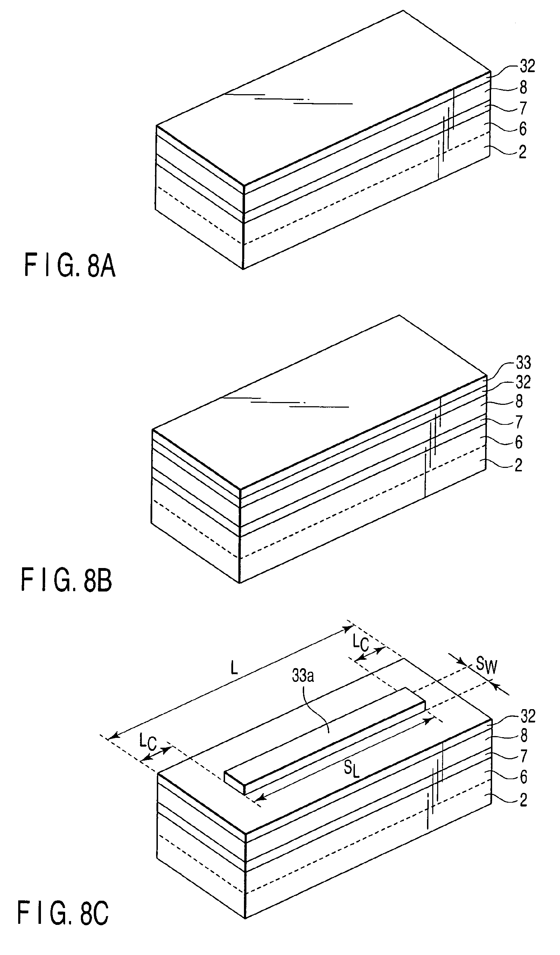

FIG. 8A is a manufacturing process view showing a method of manufacturing the optical semiconductor device according to the invention.
FIG. 8B is a manufacturing process view showing the method of manufacturing the optical semiconductor device according to the invention.
FIG. 8C is a manufacturing process view showing the method of manufacturing the optical semiconductor device according to the invention.

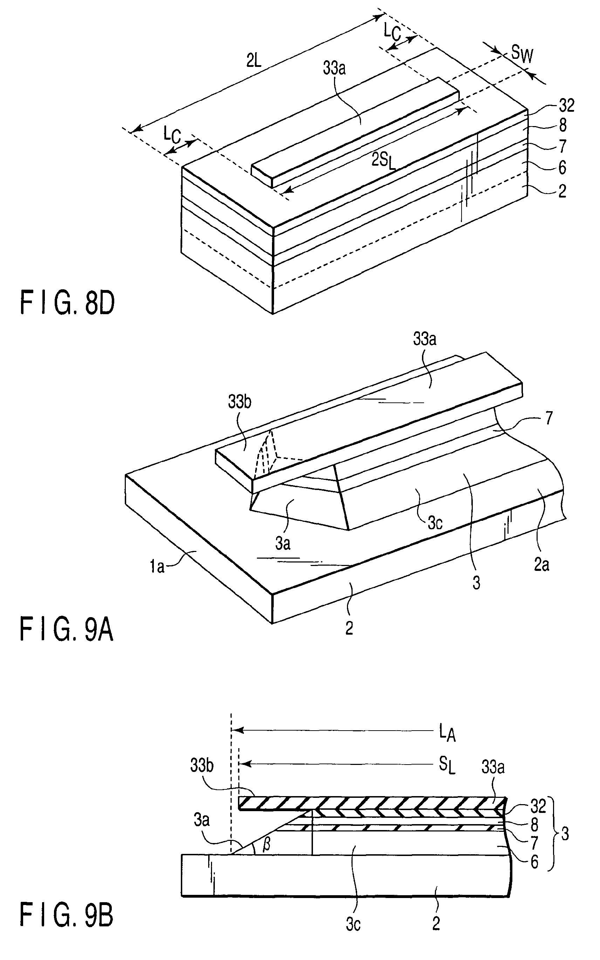

FIG. 8D is a manufacturing process view showing a modified example of the method of manufacturing the optical semiconductor device according to the invention.
FIG. 9A is a manufacturing process view showing the method of manufacturing the optical semiconductor device according to the invention.
FIG. 9B is a manufacturing process view showing the method of manufacturing the optical semiconductor device according to the invention.

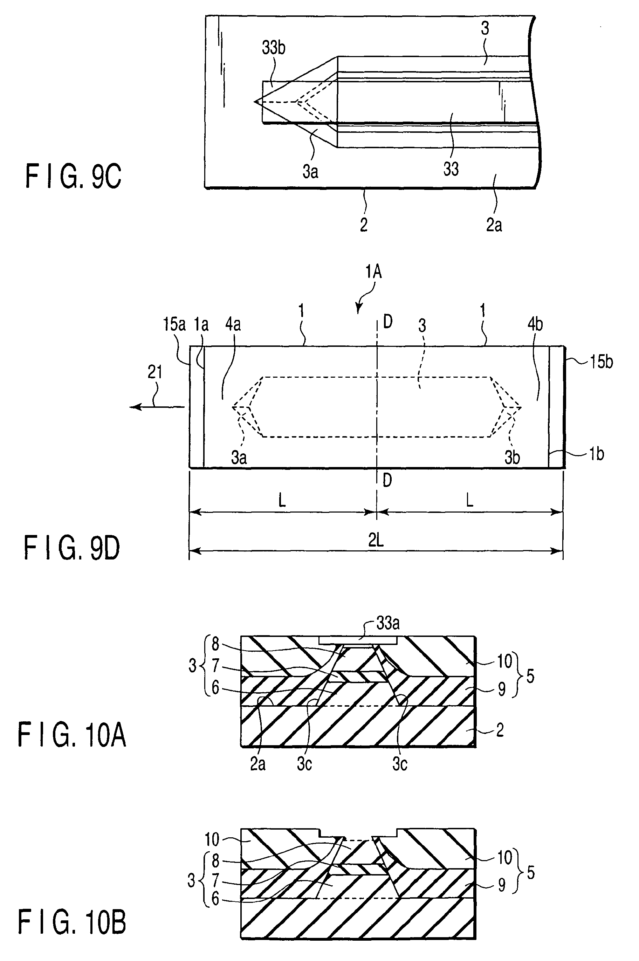

FIG. 9C is a manufacturing process view showing the method of manufacturing the optical semiconductor device according to the invention.
FIG. 9D is a manufacturing process view showing a modified example of the method of manufacturing the optical semiconductor device according to the invention.
FIG. 10A is a manufacturing process view showing the method of manufacturing the optical semiconductor device according to the invention.
FIG. 10B is a manufacturing process view showing the method of manufacturing the optical semiconductor device according to the invention.
FIG. 10C is a manufacturing process view showing the method of manufacturing the optical semiconductor device according to the invention.

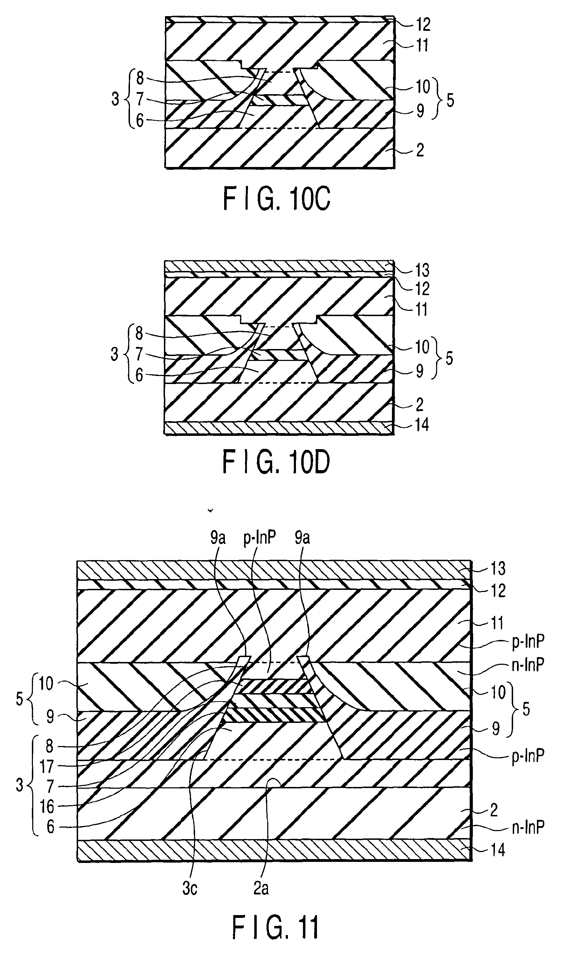

FIG. 10D is a manufacturing process view showing the method of manufacturing the optical semiconductor device according to the invention.

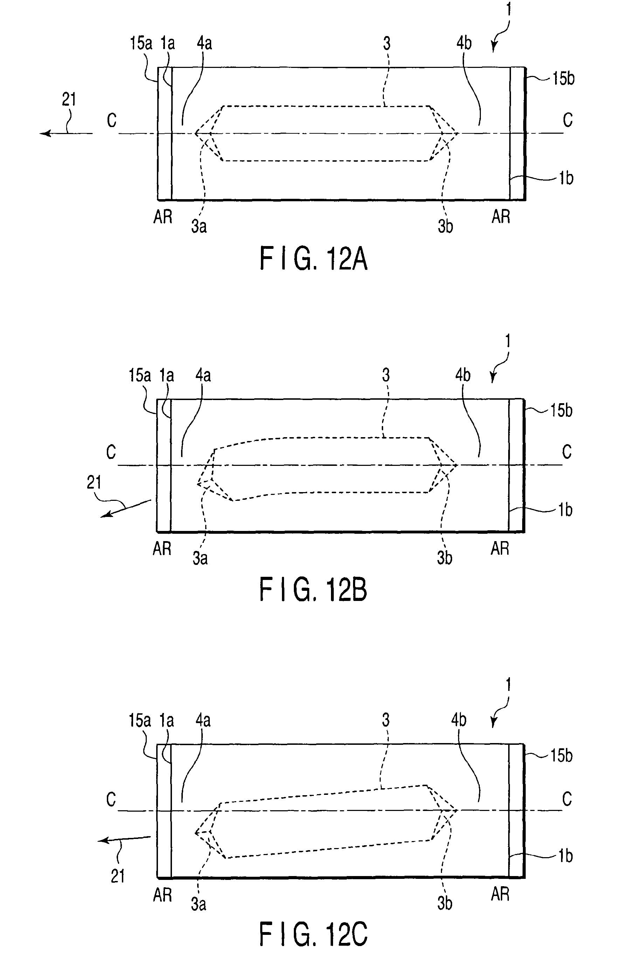

FIG. 11 is a cross-sectional view showing another configuration of the mesa stripe portion of the optical semiconductor device according to the invention.
FIG. 12A is a plan view showing a modified example of the optical semiconductor device according to the invention.
FIG. 12B is a plan view showing a modified example of the optical semiconductor device according to the invention.
FIG. 12C is a plan view showing a modified example of the optical semiconductor device according to the invention.
FIG. 13 is a schematic perspective view of a conventional semiconductor light amplifier disclosed in Patent Document 1.
FIG. 14 is a partial enlarged cross-sectional view of a window structure portion of the semiconductor light amplifier of FIG. 13.
FIG. 15 is a schematic perspective view of another conventional semiconductor light amplifier disclosed in Patent Document 1.

### Best Mode for Carrying Out the Invention

Hereinafter, best modes of carrying out the invention will be described through first to fifth embodiments.

### First Embodiment

First, an optical semiconductor device according to a first embodiment of the present invention will be described with reference to FIGS. 1 to 6.

FIG. 1 is a perspective view schematically showing a configuration of the optical semiconductor device according to the first embodiment of the invention.

FIGS. 2A to 2C are a plan view, a front view, and a side view showing a schematic configuration of the optical semiconductor device of FIG. 1, respectively.

FIG. 2D is a plan view showing a modified example of a mesa stripe portion as a configuration of a main portion of the optical semiconductor device of FIG. 1.

FIG. 3 is a cross-sectional view when a central portion in the optical semiconductor device of FIG. 1 is cut along line III-III.

FIG. 4 is a cross-sectional view when an edge region in the optical semiconductor device of FIG. 1 is cut along line IV-IV.

FIG. 5A is a graph showing wavelength characteristic of a conventional semiconductor light-emitting device.

FIG. 5B is a graph showing wavelength characteristic of the optical semiconductor device according to the invention.

FIG. 6A is a diagram showing a characteristic of a distribution of light of the optical semiconductor device according to the invention.

FIG. 6B is a partial enlarged cross-sectional view of a window structure portion of the optical semiconductor device according to the invention.

The basic configuration of the semiconductor device according to the invention, as shown in FIGS. 1 to 4, 6A and 6B, has: a semiconductor substrate 2 made of InP; an active layer 7 which is formed in parallel with a top surface 2a of the semiconductor substrate 2 above the semiconductor substrate 2; an n-type first cladding layer 6 made of InGaAsP, which is formed under the active layer 7; and window regions 4a and 4b which are formed at least one light-emitting facet of both light-emitting facets of the active layer 7, the window regions being formed between device facets 1a and 1b from the light-emitting facet, and a relationship is established in which, given that the refractive index of the n-type first cladding layer 6 is na, and the refractive index of the p-type second cladding layer 8 is nb, na > nb is obtained that the refractive index na of the n-type first cladding layer 6 is higher than the refractive index nb of the p-type second cladding layer 8, so as to deflect the distribution of a light generated at the active layer 7 toward the n-type first cladding layer 6 side.

The concrete configuration of the semiconductor device according to the invention is shown in FIGS. 1 to 4 as a schematic configuration of the semiconductor device according to the first embodiment.

An optical semiconductor device 1 of the first embodiment has a window structure in which an active layer ends in the vicinity of an facet is formed at only one end side, or at the both end sides thereof, and is used for a semiconductor light amplifier, a tunable wavelength light source apparatus, a super luminescent diode (referred to as SLD hereinafter), and the like.

The optical semiconductor device 1 according to the first embodiment has a substantially rectangular parallelepiped shape as shown in FIGS. 1, and 2A to 2D, and the n-type InP substrate 2 having an n-type impurity doped thereon is formed at the lower portion thereof.

A mesa stripe portion 3 having a parabolic edge cross-sectional shape along the longitudinal direction of the optical semiconductor device 1 on the top surface 2a of the n-type InP substrate 2 is formed along <011> direction.

The window regions 4a and 4b respectively having a predetermined length L_{C} are formed between the facets 3a and 3b in the longitudinal direction of the mesa stripe portion 3 and the facets 1a and 1b in the longitudinal direction of the optical semiconductor device 1.

Moreover, as will be described later, the facets 3a and 3b of the mesa stripe portion 3 are inclined at a predetermined angle of inclination β with respect to the <011> direction, i.e., the longitudinal direction, and are inclined at a predetermined angle of inclination θ with respect to a direction perpendicular to the longitudinal direction (the <100> direction).

As a result, the facets 3a and 3b of the mesa stripe portion 3 are formed to be at acute angles as shown in FIG. 1.

FIG. 3 is a cross-sectional view when the central portion in the optical semiconductor device 1 shown in FIG. 1 is cut along line III-III perpendicular to the longitudinal direction.

The mesa stripe portion 3 having a trapezoidal shape is formed along the <011> direction at the central portion of the top surface 2a of the n-type InP substrate 2, on which an n-type impurity has been doped, with a (100) crystalline plane being as the top surface.

The current block portions 5 are formed outside the mesa stripe portion 3 on the top surface 2a of the n-type InP substrate 2.

In the mesa stripe portion 3, the n-type first cladding layer 6 whose concentration of the n-type impurity is 1.0 × 10¹⁸ cm⁻³ is formed so as to contact the n-type InP substrate 2.

The n-type first cladding layer 6 is composed of a quaternary material (In, Ga, As, and P) with high refractive index, and the refractive index is made higher than the refractive index of the p-type second cladding layer 8 which will be described later.

The active layer 7 is formed above the n-type first cladding layer 6.

The active layer 7 is formed by a multi-quantum well structure made of non-doped InGaAsP, or non-doped InGaAsP, or a combination thereof.

Then, the p-type second cladding layer 8 whose concentration of the p-type impurity is 5 to 7 × 10¹⁷ cm⁻³ is formed above the active layer 7.

The angle of inclination of a side face 3c contacting the current block portion 5 of the mesa stripe portion 3 is set to an angle shifted by a small angle Δθ from an angle θ of 54.7° at which a (111)B crystalline plane is exposed.

In the first embodiment, the small angle Δθ is set to be ±(1° to 5°), so that the angle of inclination of the side face 3c contacting the current block portion 5 of the mesa stripe portion 3 is set to 49.3° to 53.7°, or 55.7° to 59.7°.

Further, at the top surface of the top surface 2a of the n-type InP substrate 2 contacting the current block portion 5, the (100) crystalline plane is exposed.

The current block portions 5 positioned at the both sides of the mesa stripe portion 3 are configured of p-type current block layers 9 made of p-type InP, which are positioned at the lower side, and n-type current block layers 10 made of n-type InP, which are positioned at the upper side.

Then, front ends 9a of the p-type current block layers 9 positioned at the lower side are positioned above the top surface of the mesa stripe portion 3.

Zn or Cd is included as a p-type impurity in the p-type current block layers 9.

Further, Si is included as an n-type impurity in the n-type current block layers 10 positioned at the upper side.

Then, the concentration of the n-type impurity of the n-type current block layers 10 is 2 × 10¹⁸ cm⁻³.

A p-type third cladding layer 11 whose concentration of the p-type impurity is 1.0 × 10¹⁸ cm⁻³ and which covers the top surfaces in common is formed on the top surface of the mesa stripe portion 3 and the top surfaces of the current block portions 5.

A p-type contact layer 12 made of InGaAsP is formed above the p-type third cladding layer 11.

An electrode (p-electrode) 13 is attached to the top surface of the p-type contact layer 12.

Moreover, an electrode (n-electrode) 14 is attached to the lower side of the n-type InP substrate 2.

At the facets 3a and 3b which are inclined with respect to the longitudinal direction of the mesa stripe portion 3, the n-type first cladding layer 6, the active layer 7, and the p-type second cladding layer 8, which correspond to the case in which the long mesa stripe portion 3 is obliquely cut, are exposed.

FIG. 4 is a cross-sectional view when the one window region 4b in the longitudinal direction in the optical semiconductor device 1 shown in FIG. 1 is cut along line IV-IV perpendicular to the longitudinal direction.

At the widow region 4b, the mesa stripe portion 3 and the facets 3a and 3b as shown in FIG. 1 do not exist.

As shown in FIG. 4, the current block portions 5 are formed over the entire surface of the top surface 2a of the n-type InP substrate 2.

The current block portion 5 is configured of the p-type current block layer 9 made of p-type InP, which is positioned at the lower side, and the n-type block layer 10 made of n-type InP, which is positioned at the upper side.

The p-type third cladding layer 11 which covers the top surfaces is formed over the entire surfaces of the top surfaces of the n-type current block layers 10 in the current block portions 5.

The p-type contact layer 12 is formed above the p-type third cladding layer 11.

The electrode (p-electrode) 13 is attached to the top surface of the p-type contact layer 12.

Moreover, the electrode (n-electrode) 14 is attached to the lower side of the n-type InP substrate 2.

Then, after sectioning it as a device by cleavage, antireflective films 15a and 15b are formed at the facets 1a and 1b (refer to FIGS. 1, and 2S to 2E).

Note that the cross-sectional shape shown in FIG. 4 when being cut along the line IV-IV of FIG. 1 is equal to the shapes of the facets 1a and 1b of the optical semiconductor device 1 shown in FIGS. 1, 2A to 2E.

Accordingly, the current block portions 5 are exposed at the facets 1a and 1b in the longitudinal direction of the optical semiconductor device 1, but are not exposed at the facets 3a and 3b of the mesa stripe portion 3.

As a result, the current block layers 5 configured of the p-type current block layers 9 and the n-type current block layers 10 exist between the facets 3a and 3b of the mesa stripe portion 3 and the facets 1a and 1b in the longitudinal direction of the optical semiconductor device 1.

Note that the angle of inclination θ (refer to FIGS. 2C and 3) of the side face 3c configuring the one side of the trapezoidal shape, and the angle of inclination β (refer to FIG. 2B) with respect to the longitudinal direction of the facets 3a and 3b in the mesa stripe portion 3 are determined in accordance with an etching condition at the time of forming the mesa stripe portion 3 by etching process.

When a direct driving current is applied from the electrodes 13 and 14 at the both sides to the optical semiconductor device 1 configured in this way, a laser beam is generated by causing an electric current to flow in the active layer 7 of the mesa stripe portion 3.

The laser beam generated at the active layer 7 is outputted as a laser beam 21 in the longitudinal direction shown by the arrows in FIGS. 1, and 2A to 2D.

The laser beam 21 outputted from the active layer 7 is outputted to the exterior from the facets 1a and 1b of the optical semiconductor device 1 via the current block layers 5 positioned outside in the longitudinal direction of the facets 3a and 3b from the facets 3a and 3b of the mesa stripe portion 3.

In the thus configured optical semiconductor device 1, the facets 3a and 3b of the mesa stripe portion 3 from which the laser beam 21 is outputted are positioned at the sides inward by the lengths of the window regions 4a and 4b from the facets 1a and 1b in the longitudinal direction of the optical semiconductor device 1.

Moreover, the facets 3a and 3b of the mesa stripe portion 3 are, as described above, inclined at a predetermined angle of inclination β with respect to the longitudinal direction (<011> direction) which is the output direction of the laser beam 21, and are inclined at a predetermined angle of inclination θ with respect to the direction (<100> direction) perpendicular to the longitudinal direction.

Some of the laser beam 21 emitted from the active layer 7 of the mesa stripe portion 3 is reflected on the facets 3a and 3b inclined at an angle β with respect to the output direction of the laser beam 21. However, there is no case in which the reflected laser beam 21 returns the route through which the laser beam 21 has passed.

As a result, an optical resonator in which a resonance wavelength is determined on the basis of the length between the both facets 3a and 3b of the mesa stripe portion 3 is not formed, and a fluctuation in a wavelength pitch determined on the basis of the dimensions of the window regions 4a and 4b in the wavelength characteristic P(λ) of the optical output is substantially dissolved.

Therefore, there is no case in which a large peak is brought about in a specific wavelength due to the existence of an optical resonator, or a phenomenon in which a power value is greatly fluctuated at a specific wavelength interval is brought about in the wavelength characteristic P(λ) of the optical output of the laser beam 21 outputted from the facet 1a (1b) of the optical semiconductor device 1.

As a result, in accordance with the optical semiconductor device 1, a wavelength characteristic P(λ) with satisfactory optical output in which there is no large fluctuation within a wide band wavelength range can be obtained.

FIG. 5A shows the wavelength characteristic P(λ) of an optical output actually measured at the conventional optical semiconductor device having a window structure.

FIG. 5B shows the wavelength characteristic P(λ) of an optical output actually measured at the optical semiconductor device 1 according to the first embodiment of the invention shown in FIG. 1.

In the wavelength characteristic P(λ) of the conventional optical semiconductor device shown in FIG. 5A, a large vibration has been superimposed upon the wavelength characteristic.

In contrast thereto, in the wavelength characteristic P(λ) of the optical semiconductor device 1 according to the first embodiment of the invention shown in FIG. 5B, superimposition of vibration as shown in FIG. 5A has not been generated upon the waveform of the wavelength characteristic.

Further, in the optical semiconductor device 1 according to the first embodiment of the invention, the n-type cladding layer 6 is made of InGaAsP whose refractive index is higher than that of the p-type cladding layer 8. Therefore, as shown in FIG. 6A, the distribution of the electric field intensity of the laser beam generated at the active layer 7 is made to distribute so as to deflect toward the n-type cladding layer 6 side, as characteristic a, with respect to a symmetric characteristic a' in a case in which the both cladding layers 6 and 8 are made to have the same refractive index.

Because an increase in optical loss due to valence band absorption in the p-type cladding layer 8 can be suppressed in accordance therewith, an attempt can be made to improve the characteristics of gain, optical output, and the like, as the optical semiconductor device 1.

Further, as described above, the distribution of the field intensity of the light generated at the active layer 7 is deflected toward the n-type first cladding layer 6 side by setting in a relationship in which, given that the refractive index of the n-type first cladding layer 6 is na, and the refractive index of the p-type second cladding layer 8 is nb, na > nb is obtained, such that the refractive index na of the n-type first cladding layer 6 is higher than the refractive index nb of the p-type second cladding layer 8.

In accordance therewith, as shown in FIG. 6B, the direct beam 21 generated at the active layer 7 is irradiated outward so as to direct only to the inside the ranges of the window regions 4a and 4b shown by the thick line in the illustration. Consequently, the generation of an undesired reflected light is suppressed so as not to bring about scattering and diffraction upward over the window regions 4a and 4b as shown by the broken line in the illustration, which can suppress the influence of interference between the reflected lights at the window regions 4a and 4b and the direct light.

In this case, in order to suppress the reflected light reaching the facets of the active layer 7, the lengths of the window regions 4a and 4b is set, as a predetermined length L, to be substantially a length by which a beam spot size at the portion of the reflected light can be enlarged, so that the influence of interference between the reflected light and the direct light at the window regions 4a and 4b can be two-dimensionally suppressed.

Moreover, the distribution of the light generated at the active layer 7 is deflected toward the n-type cladding layer 6 side in the optical semiconductor device 1 according to the first embodiment of the invention as compared with the device disclosed in the Patent Document 1. Therefore, the layer thickness of the p-type cladding layer 8 can be made thinner, which can reduce the time needed for forming the p-type cladding layer 8, and an attempt can be made to reduce the manufacturing cost for the entire optical semiconductor device 1.

Note that, in order to further suppress the generation of an undesired reflected light, the device may have a structure of a layout in which the mesa stripe portion 3 is inclined at a predetermined angle in the longitudinal direction as shown in FIG. 2D.

This structure makes it possible to suppress the laser beam 21 reflected at the facets 3a and 3b of the mesa stripe portion 3 to return to the route through which the laser beam 21 has passed more than the layout structure in a case in which the mesa stripe portion 3 is not inclined at a predetermined angle in the longitudinal direction, thereby it is possible to further suppress the generation of an undesired reflected light, which can further reduce the reflectance factor of the facets equivalently. Second Embodiment

Next, an optical semiconductor device according to a second embodiment of the present invention will be described with reference to FIGS. 7A to 7E.

FIGS. 7A to 7D are a plan view, a front view, a left side view, and a right side view showing a schematic configuration of another mode of the optical semiconductor device according to the invention, respectively.

FIG. 7E is a schematic view of a tunable wavelength light source apparatus using the optical semiconductor device of FIG. 7A.

Note that, in FIGS. 7A to 7E, portions which are the same as those of the optical semiconductor device 1 shown in FIGS. 1 to 4 of the first embodiment described above are denoted by the same reference numerals, and detailed descriptions of the overlapped portions will be omitted in the following descriptions.

In the optical semiconductor device 1 of the second embodiment shown in FIGS. 7A to 7D, the facet 3a at the one side of the mesa stripe portion 3 formed in the optical semiconductor device 1 is positioned inward by the distance of the window region 4a from the facet 1a of the optical semiconductor device 1, and is inclined at a predetermined angle β in the output direction of the laser beam 21.

In contrast thereto, at the other side of the mesa stripe portion 3 (on the right side in the illustration), the window region 4b is not formed, and the facet 3d is exposed to the facet 1b on the right side of the optical semiconductor device 1.

Accordingly, the facet 3d of the other side of the mesa stripe portion 3 (on the right side in the illustration) is perpendicular to the longitudinal direction of the optical semiconductor device 1.

In the optical semiconductor device 1 configured in this way, the one facet 3a of the pair of facets 3a and 3b positioned at the both sides of the mesa stripe portion 3 is inclined with respect to the output direction of the laser beam 21, and thus, there is no case in which an optical resonator is formed inside the mesa stripe portion 3.

Moreover, as shown in FIG. 7E, in the tunable wavelength light source apparatus using the optical semiconductor device 1, the desired laser beam 21 is extracted by feeding-back the light emitted from the one facet 1a (1b) in the longitudinal direction of the optical semiconductor device 1 by using wavelength selecting means such as diffraction grating 31 or the like.

Note that, the example of a Littrow layout is shown in FIG. 7E. However, other embodiments such as a Littmann layout are possible.

### Third Embodiment

Next, as a third embodiment of the present invention, a method of manufacturing the optical semiconductor device 1 of the first embodiment shown in FIGS. 1 to 4 will be described by using FIGS. 8A to 10D.

FIGS. 8A to 10D are respectively manufacturing process views showing the method of manufacturing the optical semiconductor device according to the invention and modified examples of a part thereof.

As shown in FIG. 8A, on the top surface 2a of the n-type InP substrate 2 which is formed in a rectangle with (100) crystalline plane as the top surface, and on which an n-type impurity has been doped, the n-type first cladding layer 6 whose layer thickness is 0.5 µm and whose concentration of the n-type impurity is 1.0 × 10¹⁸ cm⁻³ is formed by using a metal organic vapor phase epitaxy (MOVPE).

The active layer 7 having a multi-quantum well structure having layer thickness of 0.2 µm and made of non-doped InGaAs is formed on the top surface of the n-type first cladding layer 6.

The p-type second cladding layer 8 whose layer thickness is 0.45 µm and whose concentration of a p-type impurity is 5 to 7 × 10¹⁷ cm⁻³ is formed above the active layer 7.

Moreover, a p-type cap layer 32 made of p-type InGaAsP whose layer thickness is 0.15 µm and whose concentration of the p-type impurity is 5 to 7 × 10¹⁷ cm⁻³ is formed above the p-type second cladding layer 8.

Next, as shown in FIG. 8B, a mask layer 33 made of SiNx and having layer thickness of 80 nm is formed above the cap layer 32 by using a plasma CVD method or the like.

Moreover, as shown in FIG. 8C, by etching the mask layer 33 formed above the cap layer 32 in a stripe shape in <011> direction which is the longitudinal direction of the n-type InP substrate 2 by a photolithography technology, a mask 33a for use in the next etching is formed.

A width S_{W} of the mask 33a for use in etching is set to a width which is slightly wider than the width of the mesa stripe portion 3 of a trapezoidal shape to be formed.

Moreover, a length S_{L} in the longitudinal direction of the mask 33a for use in etching is set to be shorter than the length L in the longitudinal direction of the n-type InP substrate 2.

Accordingly, margins whose lengths are L_{C} are provided in order to form the window regions 4a and 4b at the both sides of the mask 33a above the cap layer 32.

Next, by executing etching from the upper side by using a mixed liquid of hydrochloric acid, hydrogen peroxide, and water, as an etchant, and as shown in the perspective view of FIG. 9A, the front view of FIG. 9B, and the plan view of FIG. 9C, the trapezoidal mesa stripe portion 3 whose height is h = 2.4 µm and whose length in the longitudinal direction is L is formed.

In this case, because the etching speed of the cap layer 32 is faster than those of the other portions, an etching speed of the portion at the lower side of the cap layer 32 is made faster.

Accordingly, it is possible to set the side face 3c of the mesa stripe portion 3 to a desired angle of inclination θ by adjusting the amount the side of the cap layer 32 is etched.

In the method of manufacturing the optical semiconductor device 1 of the present embodiment, by setting the cap layer 32 and the etching conditions, the angle of inclination of the side face 3c of the mesa stripe portion 3 is set to an angle (θ±Δθ) shifted by a small angle Δθ = ±(1° to 5°) from an angle θ of 54.7° by which the (111)B crystalline plane is exposed.

Next, the shape of the facet 3a of the mesa stripe portion 3 formed at the lower side of the end portion 33b in the longitudinal direction of the mask 33a will be described.

As described above, because the etching speed of the cap layer 32 under the end portion 33b of the mask 33a is faster than those of the other portions, etching is carried out from the both sides of the side faces and front facets onto the corner portions of the end portion 33b of the mask 33a, which makes the amount of etching large.

As a result, with respect to the front end shape of the mesa stripe portion 3, as shown in FIGS. 9A to 9C, an amount of etching is highest on a portion in the vicinity of the cap layer 32, and an amount of etching is lowest at a portion in the vicinity of the top surface 2a of the n-type InP substrate 2, which makes that portion have a flat pyramid shape.

Therefore, the facet 3a of the mesa stripe portion 3 is inclined so as to be not perpendicular to the top surface 2a of the n-type InP substrate 2, but at a predetermined angle β in the longitudinal direction (refer to FIG. 9B).

Specifically, the facet 3a of the mesa stripe portion 3 is inclined at a predetermined angle β with respect to the <100> direction, and is inclined at a predetermined angle θ with respect to the <011> direction.

Note that an angle of inclination β at which the facet 3a of the mesa stripe portion 3 is inclined in the longitudinal direction (refer to FIG. 9B) can be arbitrarily set within a predetermined range by arbitrarily setting the cap layer 32 and the etching conditions within a predetermined range, in the same way as an angle of inclination θ of the side surface 3c of the mesa stripe portion 3 described above.

Next, as shown in FIG. 10A, the current block portions 5 are generated at portions, which are the periphery of the mesa stripe portion 3, which are surrounded by the respective side surfaces 3c of the mesa stripe portion 3 and the top surface 2a of the n-type InP substrate 2, and at portions surrounded by the respective facets 3a and 3b of the both ends of mesa stripe portion 3 and the top surface 2a of the n-type InP substrate 2 (the window regions 4a and 4b), i.e., portions on which etching has been carried out previously.

Note that FIG. 10A shows a cross-sectional shape at a position at which the mesa stripe 3 is formed.

The basic configuration of the method of manufacturing the semiconductor device according to the invention as describe above, as shown in FIGS. 8 to 10A, has: a step of preparing the semiconductor substrate 2 made of InP; a step of forming the active layer 7 which is formed in parallel with the top surface 2a of the semiconductor substrate above the semiconductor substrate 2; a step of forming the n-type first cladding layer 6 made of InGaAsP under the active layer 7; a step of forming the p-type second cladding layer 8 made of InP above the active layer 7; and a step of forming the window regions 4a and 4b at least one light-emitting facet of the both light-emitting facets of the active layer 7, wherein a relationship is established in which, given that the refractive index of the n-type first cladding layer 6 is na, and the refractive index of the p-type second cladding layer 8 is nb, na > nb is obtained that the refractive index na of the n-type first cladding layer 6 is higher than the refractive index nb of the p-type second cladding layer 8, so as to deflect the distribution of a field intensity of a light generated at the active layer 7 toward the n-type first cladding layer 6 side.

Specifically, the p-type current block layer 9 having layer thickness of 0.7 µm, Zn as an impurity, and concentration of the impurity of 1 × 10¹⁸ cm⁻³ is formed by using a metal organic vapor phase epitaxy (MOVPE) method described above.

Further, an n-type current block layer 10 having a layer thickness of 1.15 µm, Si as an impurity, and impurity concentration of 2 × 10¹⁸ cm⁻³ is formed by using an metal organic vapor phase epitaxy (MOVPE) method described above.

The p-type current block layer 9 and the n-type current block portion 10 thus comprise the current block portion 5.

Next, as shown in FIG. 10B, by eliminating the cap layer 32 and the mask 33 above the p-type second cladding layer 8 at the mesa stripe portion 3, the top surface of the p-type second cladding layer 8 is exposed.

Next, as shown in FIG. 10C, on the top surface of the mesa stripe portion 3 and on the top surface of the current block portions 5 positioned outside the both side surfaces 3c and the both facets 3a and 3b of the mesa stripe portion 3, the p-type third cladding layer 11 which covers those respective top surfaces in common, and whose layer thickness is 3.5 µm and whose p-type impurity concentration is 1.0 × 10¹⁸ cm⁻³, is formed.

The p-type contact layer 12 made of InGaAsP whose layer thickness is 0.3 µm is formed above the third cladding layer 11.

Next, as shown in FIG. 10D, the first electrode (p-electrode) 13 is attached to the top surface of the p-type contact layer 12, and moreover, the second electrode (n-electrode) 14 is attached to the lower side of the n-type InP substrate 2.

Finally, after sectioning it as the optical semiconductor device 1 by cleavage, the antireflective films 15a and 15b are formed at the facets 1a and 1b of the optical semiconductor device 1.

As a result, the optical semiconductor device 1 is manufactured in which the facets 3a and 3b of the mesa stripe portion 3 are positioned at the side inward by the lengths of the window regions 4a and 4b from the facets 1a and 1b in the longitudinal direction, and the facets 3a and 3b are inclined with respect to the longitudinal direction, and moreover, which has the cross-sectional shape shown in FIG. 3 at the central portion in the longitudinal direction, and has cross-sectional shapes as shown in FIG. 4 at the both end portions in the longitudinal direction.

In the method of manufacturing the optical semiconductor device 1, including such manufacturing processes, as shown in 8C, the rectangular mask 33a is formed at the region on the top surface having the rectangle except for the edge portion regions in the longitudinal direction on the top surface of the cap layer 32. Thereafter, by etching the n-type first cladding layer 6, the active layer 7, the p-type second cladding layer 8 and the cap layer 32, the mesa stripe portion 3 which has a length L, and in which the facets 3a and 3b are inclined with respect to the longitudinal direction (the emission direction of a laser beam) is formed along the longitudinal direction on the n-type InP substrate 2.

In this way, in accordance with the method of manufacturing the optical semiconductor device having a window structure of the invention, the mesa stripe portion 3 in which the facets 3a and 3b in the longitudinal direction are positioned inside the optical semiconductor device 1 is formed due to one etching process, and thus, the manufacturing processes can be greatly simplified as compared with the method of manufacturing the conventional optical semiconductor device having a window structure.

Note that, when the optical semiconductor device 1 of the second embodiment shown in FIGS. 7A to 7E is manufactured, it is recommended that an optical semiconductor device 1A having a length 2L that is double the length L of the optical semiconductor device 1 to be manufactured is manufactured by using a rectangular mask 33a' having a length 2S_{L} that is double the length S_{L} of the mask 33a in FIG. 8C, and that the optical semiconductor device 1A having a length 2L that is double the optical semiconductor device 1 to be manufactured is divided into two by using a cleavage method.

Specifically, the semiconductor substrate 2, the n-type first cladding layer 6, the active layer 7, and the p-type second cladding layer 8 are respectively formed so as to have a length 2L that is double the optical semiconductor device 1 to be manufactured, in the longitudinal direction.

Further, suppose that the window regions 4a and 4b are respectively formed at the both facets different from the first principal plane and the second principal plane of the active layer 7.

As shown in FIG. 8D, on the top surface of the p-type second cladding layer 8, the cap layer 32 having a length 2L that is double the optical semiconductor device 1, and the mask 33a' having a length 2S_{L} which is shorter than the length 2L that is double the optical semiconductor device 1 to be manufactured, and a predetermined width S_{W} are successively formed.

Next, as shown in FIG. 9D, due to one etching onto the n-type first cladding layer 6, the active layer 7, the p-type second cladding layer 8 and the cap layer 32, there is formed, along the longitudinal direction on the semiconductor substrate 2, the mesa stripe portion 3 which has a length 2La corresponding to the length 2L that is double the optical semiconductor device 1 to be manufactured, and in which the both facets are inclined with respect to the longitudinal direction at a predetermined angle of inclination β, and are inclined at a predetermined angle of inclination θ with respect to the direction perpendicular to the longitudinal direction. Thus, the optical semiconductor device 1A having the length 2L that is double the optical semiconductor device 1 to be manufactured is formed.

Finally, the mesa stripe portion 3 of the optical semiconductor device 1A having the length that is double the optical semiconductor device 1 to be manufactured is divided into two along the D-D cutting-plane line at the central portion in the longitudinal direction by using a cleavage method, whereby the optical semiconductor devices 1 and 1 are cut down. Fourth Embodiment

Next, an optical semiconductor device 1 according to a fourth embodiment of the present invention will be described by using FIG. 11.

FIG. 11 is a cross-sectional view showing another configuration of a mesa stripe portion of the optical semiconductor device according to the invention.

Incidentally, in the optical semiconductor device 1 according to the first to third embodiments described above, the mesa stripe portion 3 is configured of the n-type first cladding layer 6, the active layer 7, and the p-type second cladding layer 8.

In contrast thereto, in the optical semiconductor device 1 according to the fourth embodiment, the mesa stripe portion 3 is configured by laminating the n-type first cladding layer 6, a first separate confinement heterostructure (SCH) layer 16, the active layer 7, a second SCH layer 17, and the p-type second cladding layer 8 in this order, as shown in FIG. 11.

In this case, the respective SCH layers 16 and 17 have a multilayer structure formed from a plurality of layers, and are made of InGaAsP.

Further, the active layer 7 uses, for example, a four-layered multi quantum well (MQW) structure in which four-layered well layers and five-layered barrier layers positioned at the both sides of the well layers are laminated.

The n-type first cladding layer 6 is made of InGaAsP whose refractive index is higher than the refractive index of the p-type second cladding layer 8, and is lower than the refractive indexes of the respective layers configuring the respective SCH layers 16 and 17.

Then, the refractive indexes of the plurality of layers configuring the respective SCH layers 16 and 17 are set so as to be gradually made lower as go toward the both cladding layers 6 and 8 from the active layer 7, i.e., so as to be made smaller to be separated away from the active layer (7).

When the optical semiconductor device 1 is manufactured, at the time of forming the mesa stripe portion 3 in the manufacturing method described above, the first SCH layer 16 is formed after forming the n-type first cladding layer 6.

Then, well layers of InGaAsP and barrier layers of InGaAsP are alternately made to grow on the first SCH layer 16, so that the active layer 7 of the multi-quantum well structure whose number of wells is four is formed.

Subsequently, after forming the second SCH layer 17 on the active layer 7, the p-type second cladding layer 8 is further formed on the second SCH layer 17.

The other portions are formed in the same way as the technique described above.

### Fifth Embodiment

Next, the optical semiconductor device 1 according to the fourth embodiment to which the optical semiconductor device 1 having the above configuration is applied as an super luminescent diode (SLD) will be described by using FIGS. 12A to 12C.

FIGS. 12A to 12C are respectively plan views showing a modified example of the optical semiconductor device according to the invention.

When the optical semiconductor device 1 having the above-described configuration is applied as an SLD, coupling with an optical fiber into which an output light from the SLD is incident at only one side is sufficient because the SLD is used as a light source.

Therefore, the optical semiconductor device 1 applied as an SLD is, for example, as shown in FIG. 12A, configured such that a region length of a window region at a side with which the optical fiber is not coupled is made longer than a region length of a window region at a side with which the optical fiber is coupled.

In accordance therewith, it is possible to reduce the reflectance factor of a facet of the optical semiconductor device 1.

Further, as a structure in which the reflectance factor of an facet is suppressed further than the configuration of FIG. 12A, for example, a structure shown in FIGS. 12B and 12C can be used.

Note that, the layer structure described in the first and fourth embodiments is provided as the basic structure in the optical semiconductor device 1 shown in FIGS. 12A to 12C. In the following description, components which are the same as those in the first and fourth embodiments are denoted by the same reference numbers, and descriptions thereof are omitted.

In the optical semiconductor device 1 shown in FIG. 12A, the longitudinal direction of the mesa stripe portion 3 is formed so as to make a right angle with the surface of the antireflective film 15a which is the output facet.

In contrast thereto, in the optical semiconductor device 1 shown in FIG. 12B or 12C, the mesa stripe portion 3 is formed such that an output light is made to have an angle which is not a right angle with respect to the surface of the antireflective film 15a which is the output facet (corresponding to the optical axis C-C of FIG. 12A).

Namely, in the optical semiconductor device 1 shown in FIG. 12B, a part of the mesa stripe portion 3 is inclined, and the optical semiconductor device 1 is configured such that the mesa stripe portion 3 is gradually inclined from the halfway position up to the facet 3a which are closer to the side at which the region length of the window region with which the optical fiber is coupled is shorter, and is inclined at a predetermined angle such that an output light has an angle which is not a right angle with respect to the surface of the antireflective film 15a in the vicinity of the facet 3a.

Further, in the optical semiconductor device 1 shown in FIG. 12C, the entire mesa stripe portion 3 is configured to be inclined at a predetermined angle such that an output light has an angle which is not a right angle with respect to the surface of the antireflective film 15a.

Note that, in the optical semiconductor devices 1 of FIGS. 12B and 12C, a part of or the entire mesa stripe portion 3 is inclined such that an output light has an angle which is not a right angle with respect to the surface of the antireflective film 15a which is the output facet, in the configuration having the window regions at the both sides.

However, even in a case of an optical semiconductor device having a window region at only one side, the configurations of the stripe portions 3 of FIGS. 12B and 12C can be used.

In this way, in the fifth embodiment, it is configured such that a part of or the entire mesa stripe portion 3 is inclined such that an output light has an angle which is not a right angle with respect to an output facet (the surface of the antireflective film 15a) in an optical semiconductor device having a window region at one side or window regions at the both sides. Accordingly, the effect that the reflectance factors at the facets are equivalently suppressed is provided in the same way as in the case of FIG. 2D.

Note that, in the optical semiconductor devices 1 shown in FIGS. 12B and 12C in the fifth embodiment, the greater the angle of inclination of an output light with respect to the surface of the antireflective film 15a which is the output facet is, the lower the reflectance factors at the facets can be reduced to.

However, if the angle of inclination is made too large, an angle of fetching light is made large, and it is difficult to couple with the optical fiber. Therefore, when the optical axis C-C of FIG. 12A is made to be 0°, the angle of inclination is preferably set to about 8° for practical purposes.

In the semiconductor device of the invention, InGaAsP, whose refractive index is high, is used as the n-type first cladding layer 6, and thus, a coefficient for optical containment to the active layer 7 becomes lower than that of the conventional optical semiconductor device.

Therefore, there is the advantage that a maximum active layer width for maintaining a single mode can be broadened.

On the other hand, it has been known that, when a semiconductor light amplifier, or an SLD, is structured such that an active layer is inclined with respect to a light-emitting facet, the reflectance factors of the facets are reduced exponentially with respect to a size of a beam spot emitted from the active layer.

Accordingly, as in the invention, in a structure in which a size of a beam spot emitted from the active layer 7 is made substantially large by using the optical semiconductor device 1 having a window region at one side or window regions at the both sides, the effect due to the active layer stripe being inclined with respect to the facets is extremely high.

For example, when a size of a beam spot emitted from the active layer 7 is enlarged from 1.5 µm to 2.5 µm, the reflectance factor at a facet is reduced to about 1/10 thereof when the angle of inclination is 6°, and is reduced to about 1/100 thereof when the angle of inclination is 8°.

Further, the optical semiconductor devices 1 according to the first to fifth embodiments have been described on the basis of an optical semiconductor device having a buried structure. However, it goes without saying that the invention can be applied to an optical semiconductor device having a ridge structure.

In this way, in the optical semiconductor device 1 of the invention, when the mesa stripe portion 3 is structured from an n-type cladding layer (the n-type first cladding layer 6), the active layer 7, and a p-type cladding layer (the p-type second cladding layer 8), the n-type cladding layer 6 is made of a quaternary material (In, Ga, As, P) whose refractive index is higher than that of the p-type cladding layer 8.

Further, when the mesa stripe portion 3 is composed of an n-type cladding layer (the n-type first cladding layer 6), the first SCH layer 16, the active layer 7, the second SCH layer 17, and a p-type cladding layer (the p-type second cladding layer 8), the n-type cladding layer 6 is made of InGaAsP, whose refractive index is higher than that of the p-type cladding layer 8, and is lower than the refractive indexes of the respective layers configuring the respective SCH layers.

Consequently, the distribution of the electric field intensity of a light generated at the active layer 7 can be shifted from the side of the p-type second cladding layer 8 made of P-InP as a p-type cladding layer to the side of the n-type first cladding layer 6.

As a result, because it is possible to suppress valence band absorption in the semiconductor at the p-side, an attempt can be made to improve the characteristics of gain, optical output, and the like.

As described above, because a light from the active layer is diffracted at the window region of the conventional optical semiconductor device disclosed in the Patent Document 1, it is necessary to thicken the layer thicknesses of the p-type buried layer and the cladding layers in accordance with a size of a beam spot emitted from the active layer.

In contrast thereto, in the optical semiconductor device 1 of the invention, the distribution of the electric field intensity of a light generated at the active layer 7 is shifted to the side of the n-type first cladding layer 6, thereby making it possible to suppress the generation of an undesired reflected light so as not to bring about undesired scattering or diffraction in a light generated at the active layer 7 at window regions. Therefore, the layer thickness of the cladding layers can be made thinner than those of the conventional semiconductor device.

In accordance therewith, the time needed for forming cladding layers by a vapor phase epitaxy method can be made shorter than that in the prior art in accordance with the optical semiconductor device 1 of the invention, and the time needed for manufacturing the entire optical semiconductor device 1 can be made shorter, and an attempt can be made to reduce the manufacturing cost.

In addition thereto, with respect to the above-described embodiments, it goes without saying that various modifications and applications are possible within a range which does not deviate from the gist of the present invention.

Accordingly, as described above in detail, in order to realize an optical semiconductor device which can easily suppress the influence of interference at a window region in which an active layer ends in the vicinity of the facet, the invention provides an optical semiconductor device that enable to suppress the generation of an undesired reflected light so as not to bring about undesired scattering or diffraction of the light generated at the active layer by shifting the distribution of the electric field intensity of a light generated at the active layer from the side of a p-type cladding layer to the side of an n-type cladding layer, and that can effectively suppress the influence of interference due to the reflected light from an electrode, without the layer thickness of the cladding layer at the p-side being made as thick as that in the prior art, and without taking a long time for manufacture and increasing the manufacturing cost.

## Claims

1. An optical semiconductor device **characterized by** comprising:
a semiconductor substrate made of InP;
an active layer which is formed in parallel with a top surface of the semiconductor substrate above the semiconductor substrate;
an n-type first cladding layer made of InGaAsP, which is formed under the active layer;
a p-type second cladding layer made of InP, which is formed above the active layer; and
at least one window region which is formed at at least one light-emitting facet of both light-emitting facets of the active layer, the window region being formed between at least one of the device facets from the at least one light-emitting facet, wherein
a relationship is established in which, given that a refractive index of the n-type first cladding layer is na, and a refractive index of the p-type second cladding layer is nb, na > nb is obtained that the refractive index na of the n-type first cladding layer is higher than the refractive index nb of the p-type second cladding layer, so as to deflect a distribution of electric field strength of a light generated at the active layer toward the n-type first cladding layer side.

2. The optical semiconductor device according to claim 1, **characterized in that** a length of the window region is set to a length which enables to enlarge a beam spot size at the device facet having the window region.

3. The optical semiconductor device according to claim 1, **characterized by** further comprising:
a mesa stripe portion in which some of respective layers of the n-type first cladding layer, the active layer, and the p-type second cladding layer are formed in a mesa type;
a current block portion including: first current block layers made of p-type InP, which are formed so as to contact the semiconductor substrate and the n-type first cladding layer with each one plane thereof at both sides of the mesa stripe portion; and second current block layers made of n-type InP, which are formed so as to contact the p-type second cladding layer with each one plane thereof at the both sides of the respective layers formed in a mesa type, and so as to contact each another plane of the first current block layers with each another plane thereof;
a p-type third cladding layer which covers a top surface of the mesa stripe portion and a top surface of the current block portion in common;
a p-type contact layer formed above the p-type third cladding layer;
a first electrode attached to a top surface of the p-type contact layer;
a second electrode attached to a lower side of the semiconductor substrate; and
at least one antireflective film formed at at least one of the device facets having the window region of an optical semiconductor device cut down as the optical semiconductor device by cleavage.

4. The optical semiconductor device according to claim 1, **characterized by** further comprising:
a first separate confinement heterostructure (SCH) layer made of InGaAsP, which is formed between the active layer and the n-type first cladding layer; and
a second SCH layer made of InGaAsP, which is formed between the active layer and the p-type second cladding layer, wherein
respective refractive indexes of the first SCH layer and the second SCH layer are set to be higher than the refractive index of the n-type first cladding layer.

5. The optical semiconductor device according to claim 4, **characterized in that** the active layer includes a multi quantum well (MQW) structure having a plurality of layers including a plurality of well layers and a plurality of barrier layers which are positioned at both sides of each well layer in the plurality of well layers.

6. The optical semiconductor device according to claim 5, **characterized in that**
the first SCH layer includes a multilayer structure formed from a plurality of layers, and
the second SCH layer includes a multilayer structure formed from a plurality of layers.

7. The optical semiconductor device according to claim 6, **characterized in that**
a great and small relationship among refractive indexes of the respective layers of said plurality of barrier layers in the active layer, said plurality of layers in the first SCH layer, and said plurality of layers in the second SCH layer is set such that the refractive index of said plurality of barrier layers in the active layer is highest, and the refractive indexes are made lower as are separated away from the active layer, including the relationship in which the refractive index na of the n-type first cladding layer is higher than the refractive index nb of the p-type second cladding layer.

8. The optical semiconductor device according to claim 7, **characterized by** further comprising:
a mesa stripe portion in which some of the respective layers of the n-type first cladding layer, the first SCH layer, the active layer, the second SCH layer, and the p-type second cladding layer are formed in a mesa type;
a current block portion including: first current block layers made of p-type InP, which are formed so as to contact the semiconductor substrate and the n-type first cladding layer with each one plane thereof at both sides of the mesa stripe portion; and second current block layers made of n-type InP, which are formed so as to contact the p-type second cladding layer with each one plane thereof at both sides of the respective layers formed in a mesa type, and so as to contact each another plane of the first current block layers with each another plane thereof;
a p-type third cladding layer which covers a top surface of the mesa stripe portion and a top surface of the current block portion in common;
a p-type contact layer formed above the p-type third cladding layer;
a first electrode attached to a top surface of the p-type contact layer;
a second electrode attached to a lower side of the semiconductor substrate; and
at least one antireflective film formed at at least one of the device facets having the window region of an optical semiconductor device cut down as the optical semiconductor device by cleavage.

9. The optical semiconductor device according to claim 3 or 8, **characterized in that**
at least one facet of both facets of the mesa stripe portion is inclined at a predetermined angle β with respect to a longitudinal direction which is an output direction of a light generated at the active layer, and is formed so as to be an acute angle inclined at a predetermined angle θ with respect to a direction perpendicular to the longitudinal direction.

10. The optical semiconductor device according to claim 3 or 8, **characterized in that** the mesa stripe portion is formed to be a layout structure in which the mesa stripe portion is inclined at a predetermined angle in the longitudinal direction thereof.

11. The optical semiconductor device according to claim 3 or 8, **characterized in that**
the window region is formed such that one is as a window region which is coupled with an optical fiber, and another one is as a window region which is not coupled with an optical fiber at the both light-emitting facets of the active layer,
a region length of the window region which is not coupled with an optical fiber is longer than a region length of the window region which is coupled with an optical fiber, and
the mesa stripe portion, in the longitudinal direction, is formed to make a right angle with the surfaces of the antireflective film which is output facets, so that the device is applied as a super luminescence diode.

12. The optical semiconductor device according to claim 3 or 8, **characterized in that**
window regions are formed such that one is as a window region which is coupled with an optical fiber, and another one is as a window region which is not coupled with an optical fiber at the both light-emitting facets of the active layer,
a region length of the window region which is not coupled with an optical fiber is longer than a region length of the window region which is coupled with an optical fiber, and
the mesa stripe portion, in the longitudinal direction, is partially or entirely formed to be inclined at a predetermined angle so as to make an angle of an output light which is not a right angle with respect to the surfaces of the antireflective films which is output facets, so that the device is applied as super luminescence diode.

13. The optical semiconductor device according to claim 3 or 8, **characterized in that**
the window region is formed as a window region at only one light-emitting facet of the both light-emitting facets of the active layer,
one facet of the mesa stripe portion is positioned inward by a distance of the window region from the facet of the optical semiconductor device facing thereto, and is inclined at a predetermined angle β in an output direction of the light generated at the active layer, and
another facet of the mesa stripe portion, at which the window region is not formed, is exposed to the facet of the optical semiconductor device facing thereto, and is formed so as to be perpendicular to the longitudinal direction of the optical semiconductor device.

14. A method of manufacturing an optical semiconductor device, **characterized by** comprising:
a step of preparing a semiconductor substrate made of InP;
a step of forming an active layer in parallel with a top surface of the semiconductor substrate above the semiconductor substrate;
a step of forming an n-type first cladding layer made of InGaAsP under the active layer;
a step of forming a p-type second cladding layer made of InP above the active layer; and
a step of forming at least one window region at at least one light-emitting facet of both light-emitting facets of the active layer, between at least one of device facets from the light-emitting facet, wherein
a relationship is established in which, given that a refractive index of the n-type first cladding layer is na, and a refractive index of the p-type second cladding layer is nb, na > nb is obtained that the refractive index na of the n-type first cladding layer is higher than the refractive index nb of the p-type second cladding layer, so as to deflect a distribution of electric field strength of a light generated at the active layer toward the n-type first cladding layer side.

15. The method of manufacturing an optical semiconductor device, according to claim 14, **characterized in that** a length of the window region is set to a length which enables to enlarge a beam spot size at the device facet having the window region.

16. The method of manufacturing an optical semiconductor device, according to claim 14, **characterized by** further comprising:
a step of forming some of respective layers of the n-type first cladding layer, the active layer, and the p-type second cladding layer as a mesa stripe portion in a mesa type;
a step of forming a current block portion including: first current block layers made of p-type InP, which are formed so as to contact the semiconductor substrate and the n-type first cladding layer with each one plane thereof at both sides of the mesa stripe portion; and second current block layers made of n-type InP, which are formed so as to contact the p-type second cladding layer with each one plane thereof at the both sides of the respective layers formed in a mesa type, and so as to contact each another plane of the first current block layers with each another plane thereof;
a step of forming a p-type third cladding layer which covers a top surface of the mesa stripe portion and a top surface of the current block portion in common;
a step of forming a p-type contact layer above the p-type third cladding layer;
a step of attaching a first electrode to a top surface of the p-type contact layer;
a step of attaching a second electrode to a lower side of the semiconductor substrate; and
a step of forming at least one antireflective film at at least one of the device facets having the window region of an optical semiconductor device cut down as the optical semiconductor device by cleavage.

17. The method of manufacturing an optical semiconductor device, according to claim 14, **characterized by** further comprising:
a step of forming a first separate confinement heterostructure (SCH) layer made of InGaAsP between the active layer and the n-type first cladding layer; and
a step of forming a second SCH layer made of InGaAsP between the active layer and the p-type second cladding layer, wherein
respective refractive indexes of the first SCH layer and the second SCH layer are set to be higher than a refractive index of the n-type first cladding layer.

18. The method of manufacturing an optical semiconductor device, according to claim 14, **characterized in that** the active layer includes a multi quantum well (MQW) structure having a plurality of layers which includes a plurality of well layers and a plurality of barrier layers which are positioned at both sides of each well layer in the plurality of well layers.

19. The method of manufacturing an optical semiconductor device, according to claim 18, **characterized in that**
the first SCH layer includes a multilayer structure formed from a plurality of layers, and
the second SCH layer includes a multilayer structure formed from a plurality of layers.

20. The method of manufacturing an optical semiconductor device, according to claim 19, **characterized in that**
a great and small relationship among refractive indexes of respective layers of said plurality of barrier layers in the active layer, said plurality of layers in the first SCH layer, and said plurality of layers in the second SCH layer is set such that the refractive index of said plurality of barrier layers in the active layer is highest, and the refractive indexes are made lower as are separated away from the active layer including the relationship in which the refractive index na of the n-type first cladding layer is higher than the refractive index nb of the p-type second cladding layer.

21. The method of manufacturing an optical semiconductor device, according to claim 20, **characterized by** further comprising:
a step of forming some of the respective layers of the n-type first cladding layer, the first SCH layer, the active layer, the second SCH layer, and the p-type second cladding layer as a mesa stripe portion in a mesa type;
a step of forming a current block portion including: first current block layers made of p-type InP, which are formed so as to contact the semiconductor substrate and the n-type first cladding layer with each one plane thereof at both sides of the mesa stripe portion; and second current block layers made of n-type InP, which are formed so as to contact the p-type second cladding layer with each one plane thereof at both sides of the respective layers formed in a mesa type, and so as to contact the other planes of the first current block layers with each another plane thereof;
a step of forming a p-type third cladding layer which covers a top surface of the mesa stripe portion and a top surface of the current block portion in common;
a step of forming a p-type contact layer above the p-type third cladding layer;
a step of attaching a first electrode to a top surface of the p-type contact layer;
a step of attaching a second electrode to a lower side of the semiconductor substrate; and
a step of forming at least one antireflective film at at least one of both light-emitting facets of an optical semiconductor device cut down as the optical semiconductor device by cleavage.

22. The method of manufacturing an optical semiconductor device, according to claim 16,
**characterized in that**
the step of forming a mesa stripe portion comprises:
a step of successively forming a cap layer on a top surface of the p-type second cladding layer, and a mask having a predetermined length S_{L} and a predetermined width S_{W}; and
a step of forming a mesa stripe portion having a predetermined length Lₐ along a longitudinal direction on the semiconductor substrate by means of one round etching onto the n-type first cladding layer, the active layer, the p-type second cladding layer, and the cap layer, at least one facet of both facets being inclined with respect to the longitudinal direction (an emission direction of a laser beam), and the mesa stripe portion being inclined with respect to a direction perpendicular to the longitudinal direction, and
at least one facet of the both facets of the mesa stripe portion is inclined at a predetermined angle β with respect to the longitudinal direction which is an output direction of a light generated at the active layer, and is formed so as to be an acute angle inclined at a predetermined angle θ with respect to a direction perpendicular to the longitudinal direction.

23. The method of manufacturing an optical semiconductor device, according to claim 21, **characterized in that**
the step of forming a mesa stripe portion comprises:
a step of successively forming a cap layer on a top surface of the p-type second cladding layer, and a mask having a predetermined length S_{L} and a predetermined width S_{W}; and
a step of forming a mesa stripe portion having a predetermined length Lₐ along a longitudinal direction on the semiconductor substrate by means of one round etching onto the n-type first cladding layer, the first SCH layer, the active layer, the second SCH layer, the p-type second cladding layer, and the cap layer, the facets being inclined with respect to the longitudinal direction (an emission direction of a laser beam), and the mesa stripe portion being inclined with respect to a direction perpendicular to the longitudinal direction, and
at least one facet of the both facets of the mesa stripe portion is inclined at a predetermined angle β with respect to the longitudinal direction which is an output direction of a light generated at the active layer, and is formed so as to be an acute angle inclined at a predetermined angle θ with respect to a direction perpendicular to the longitudinal direction.

24. The method of manufacturing an optical semiconductor device, according to claim 16 or 21,
**characterized in that**
the step of forming a mesa stripe portion comprises:
a step of forming the mesa stripe portion to be a layout structure in which the mesa stripe portion is inclined at a predetermined angle in the longitudinal direction thereof.

25. The method of manufacturing an optical semiconductor device, according to claim 16 or 21,
**characterized in that**
the step of forming window regions has:
a step of forming a window region having a predetermined region length which is coupled with an optical fiber at one light-emitting facet of the both light-emitting facets of the active layer; and
a step of forming a window region which has a region length longer than the region length of the window region, and which is not coupled with an optical fiber, at the other light-emitting facet of the both light-emitting facets of the active layer, and
the mesa stripe portion, in the longitudinal direction, is formed to make a right angle with the surfaces of the antireflective films which are output facets, so that the device is applied as a super luminescence diode.

26. The method of manufacturing an optical semiconductor device, according to claim 16 or 21,
**characterized in that**
the step of forming window regions comprises:
a step of forming a window region having a predetermined region length which is coupled with an optical fiber at one light-emitting facet of the both light-emitting facets of the active layer; and
a step of forming a window region which has a region length longer than the region length of the window region, and which is not coupled with an optical fiber, at the other light-emitting facet of the both light-emitting facets of the active layer, and
the mesa stripe portion, in the longitudinal direction, is partially or entirely formed to be inclined at a predetermined angle so as to have an angle which is not a right angle with respect to the surfaces of the antireflective films which is output facets, so that the device is applied as a super luminescence diode.

27. The method of manufacturing an optical semiconductor device, according to claim 16 or 21, **characterized by** comprising:
a step of forming the window region as a window region at only one light-emitting facet of the both light-emitting facets of the active layer;
a step of forming one facet of the mesa stripe portion so as to be positioned inward by a distance of the window region from the facet of the optical semiconductor device facing thereto, and so as to be inclined at a predetermined angle β in an output direction of the light generated at the active layer; and
a step of forming the other facet of the mesa stripe portion, at which the window region is not formed, so as to be exposed to the facet of the optical semiconductor device facing thereto, and so as to be perpendicular to the longitudinal direction of the optical semiconductor device.

28. The method of manufacturing an optical semiconductor device, according to claim 14, **characterized in that**
the semiconductor substrate, the n-type first cladding layer, the active layer, and the p-type second cladding layer each have a length that is double the length of the optical semiconductor device to be manufactured in the longitudinal direction,
the window regions are respectively formed at the both light-emitting facets of the active layer,
the method further comprising:
a step of successively forming a cap layer having a length that is double the optical semiconductor device to be manufactured, on a top surface of the p-type second cladding layer, and a mask having a length shorter than the length that is double the optical semiconductor device to be manufactured, and a predetermined width;
a step of forming an optical semiconductor device having a length that is double the optical semiconductor device to be manufactured by forming a mesa stripe portion having a length corresponding to the length that is double the optical semiconductor device to be manufactured, along a longitudinal direction on the semiconductor substrate, by means of one round etching onto the n-type first cladding layer, the active layer, the p-type second cladding layer, and the cap layer, the both facets being inclined with respect to the longitudinal direction at a predetermined angle of inclination θ, and the mesa stripe portion being inclined at a predetermined angle of inclination β with respect to a direction perpendicular to the longitudinal direction; and
a step of sectioning the optical semiconductor device to be manufactured by dividing the mesa stripe portion of the optical semiconductor device having the length that is double the optical semiconductor device to be manufactured into two at a central portion in the longitudinal direction by using a cleavage technique.
